(19) Europäisches Patentamt / European Patent Office / Office européen des brevets

(11) **EP 4 769 290 A1**

(12) **EUROPEAN PATENT APPLICATION**
published in accordance with Art. 153(4) EPC

(43) Date of publication:
01.07.2026 Bulletin 2026/27

(21) Application number: 25857188.4

(22) Date of filing: 11.07.2025

(51) International Patent Classification (IPC):
G06Q 50/40 (2024.01)     G06Q 50/10 (2012.01)
B60L 58/12 (2019.01)     G01R 31/382 (2019.01)
G08B 21/18 (2006.01)     B60L 58/10 (2019.01)
G06V 20/62 (2022.01)     H01M 10/42 (2006.01)

(52) Cooperative Patent Classification (CPC):
B60L 58/10; B60L 58/12; G01R 31/382;
G06Q 50/10; G06Q 50/40; G06V 20/62;
G08B 21/18; H01M 10/42

(86) International application number:
PCT/KR2025/010198

(87) International publication number:
WO 2026/043101 (26.02.2026 Gazette 2026/09)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 22.08.2024 KR 20240112949
23.08.2024 KR 20240113766
19.05.2025 KR 20250064633

(71) Applicant: LG Energy Solution, Ltd.
Seoul 07335 (KR)

(72) Inventors:
• LEE, Han-Sun
  Daejeon 34122 (KR)
• KOO, Ja-Hoon
  Daejeon 34122 (KR)
• LEE, Hye-Young
  Daejeon 34122 (KR)

(74) Representative: Plasseraud IP
104 Rue de Richelieu
CS92104
75080 Paris Cedex 02 (FR)

(54) **VEHICLE ENTRY MANAGEMENT METHOD, VEHICLE ENTRY MANAGEMENT APPARATUS AND VEHICLE ENTRY MANAGEMENT SYSTEM INCLUDING SAME**

(57) A vehicle entry management method, a vehicle entry management apparatus and a vehicle entry management system are provided. The vehicle entry management method according to the present disclosure includes acquiring vehicle location information and vehicle battery information of an electric vehicle; and performing a vehicle entry management operation related to entry of the electric vehicle into a facility based on the vehicle location information and the vehicle battery information.

FIG. 1

**Description**

TECHNICAL FIELD

The present disclosure relates to electric vehicle entry management in facility.

This application is based on and claims priority from Korean Patent Application No. 10-2024-0112949 filed on August 22, 2024, Korean Patent Application No. 10-2024-0113766 filed on August 23, 2024 and Korean Patent Application No. 10-2025-0064633 filed on May 19, 2025, the disclosure of which is incorporated herein in its entirety by reference.

BACKGROUND ART

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Batteries on the market now include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

The demand for electric vehicles is dramatically growing, and accordingly, accident risks and hazards including fires and explosions in electric vehicles are significantly increasing.

In particular, due to the features of different types of facilities where vehicles enter and exit, such as underground parking lots and ships, numerous vehicles may be tightly parked densely in the facilities, so when a fire occurs in even a single electric vehicle, the severity of the fire may increase rapidly. Recently, after fires in underground parking lots in residential complexes, in some regions in some countries including South Korea, electric vehicles are permitted to enter underground parking lots only when they meet predefined entry requirements (for example, state of charge (SOC) 90% or lower).

Moreover, unlike in driving, because most vehicles are left unattended for a long time while parked, it is difficult to immediately respond to abnormal signs of electric vehicles or dangerous situations occurred.

However, prohibiting all electric vehicles from entering facilities may cause many social and economic problems such as outrage among electric vehicle users.

DISCLOSURE

Technical Problem

The present disclosure is designed to solve the above-described problems, and therefore the present disclosure is directed to providing a method and apparatus for allowing or disallowing electric vehicle entry into a facility based on vehicle location information and vehicle battery information of the electric vehicle.

The present disclosure is further directed to providing a method and apparatus for facilitating pre-discharge of an electric vehicle traveling toward a facility to get the electric vehicle to meet the entry requirements at the time when the electric vehicle arrives at the facility.

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

Technical Solution

A vehicle entry management method according to an aspect of the present disclosure includes acquiring vehicle location information and vehicle battery information of an electric vehicle; and performing a vehicle entry management operation related to entry of the electric vehicle into a facility based on the vehicle location information and the vehicle battery information.

Performing the vehicle entry management operation may include determining whether a real-time battery state of charge (SOC) based on the vehicle battery information is equal to or less than a first reference SOC when it is determined, based on the vehicle location information, that the electric vehicle has arrived at the facility; and performing an operation of disallowing the entry of the electric vehicle when the real-time battery SOC is determined to be higher than the first reference SOC.

The operation of disallowing the entry may include at least one of a function of transmitting a disallowed entry notification to the electric vehicle or a function of controlling a barrier gate installed at an entrance of the facility into a closed state.

Performing the vehicle entry management operation may include determining whether a real-time battery SOC based on the vehicle battery information is equal to or less than a first reference SOC when it is determined, based on the vehicle location information, that the electric vehicle has arrived at the facility; and performing an operation of allowing the entry of the electric vehicle when the real-time battery SOC is determined to be equal to or less than the first reference SOC.

The operation of allowing the entry may include at least one of a function of transmitting an allowed entry notification to the electric vehicle or a function of controlling a barrier gate installed at an entrance of the facility into an open state.

Performing the vehicle entry management operation may include determining a first expected battery SOC at an expected time of arrival at the facility based on the vehicle location information and the vehicle battery information when it is determined, based on the vehicle location information, that the electric vehicle has not yet arrived at the facility; and performing a first pre-discharging operation for the electric vehicle when the first expected battery SOC is higher than the first reference SOC.

The first pre-discharging operation may include at least one of a function of changing a driving route of the electric vehicle, a function of changing a driving mode of the electric vehicle, a function of forcibly activating at least one electrical equipment of the electric vehicle, a function of activating cell balancing for a battery of the electric vehicle, or a function of supplying charge power to another electric vehicle.

The vehicle entry management method may include determining, after the electric vehicle has entered the facility, a second expected battery SOC at an expected time of arrival of the electric vehicle at a new destination; and performing a second pre-discharging operation using a charger installed at the facility when the second expected battery SOC is higher than a second reference SOC.

A vehicle entry management apparatus according to another aspect of the present disclosure includes an information input/output module configured to acquire vehicle location information and vehicle battery information of an electric vehicle; and a control module configured to perform a vehicle entry management operation related to entry of the electric vehicle into a facility based on the vehicle location information and the vehicle battery information.

The control module may be configured to determine whether a real-time battery SOC based on the vehicle battery information is equal to or less than a first reference SOC when it is determined, based on the vehicle location information, that the electric vehicle has arrived at the facility. The control module may be configured to perform an operation of disallowing the entry of the electric vehicle when the real-time battery SOC is determined to be higher than the first reference SOC.

The operation of disallowing the entry may include at least one of a function of transmitting a disallowed entry notification to the electric vehicle or a function of controlling a barrier gate installed at an entrance of the facility into a closed state.

The control module may be configured to determine whether a real-time battery SOC based on the vehicle battery information is equal to or less than a first reference SOC when it is determined, based on the vehicle location information, that the electric vehicle has arrived at the facility. The control module may be configured to perform an operation of allowing the entry of the electric vehicle into the facility when the real-time battery SOC is determined to be equal to or less than the first reference SOC.

The control module may be configured to determine a first expected battery SOC at an expected time of arrival at the facility based on the vehicle location information and the vehicle battery information when it is determined, based on the vehicle location information, that the electric vehicle has not yet arrived at the facility. The control module may be configured to perform a first pre-discharging operation for the electric vehicle when the first expected battery SOC is determined to be higher than the first reference SOC.

The first pre-discharging operation may include at least one of a function of changing a driving route of the electric vehicle, a function of changing a driving mode of the electric vehicle, a function of forcibly activating at least one electrical equipment of the electric vehicle, a function of activating cell balancing for a battery of the electric vehicle, or a function of supplying charge power to another electric vehicle.

The control module may be configured to determine, after the electric vehicle entered the facility, a second expected battery SOC at an expected time of arrival of the electric vehicle at a new destination. The control module may be configured to perform a second pre-discharging operation using a charger installed at the facility when the second expected battery SOC is higher than a second reference SOC.

Advantageous Effects

According to at least one of the embodiments of the present disclosure, electric vehicle entry into facilities may be allowed or disallowed based on vehicle location information and/or vehicle battery information. Accordingly, electric vehicles having high potential risks due to high battery state of charge (SOC) may be prohibited from entering facilities, thereby significantly reducing the frequency and severity of fire/explosion accidents in facilities.

Furthermore, according to at least one of the embodiments of the present disclosure, before arrival at facilities, preemptive measures (for example, pre-discharging) may be taken to sufficiently reduce the battery SOC of electric vehicles during the remaining time until the electric vehicles arrive at the facilities. Accordingly, the electric vehicles may be permitted to enter the facilities without delay upon arrival.

Additionally, according to at least one of the embodiments of the present disclosure, before arrival at facilities, electric vehicles may be notified of entry guide information (for example, whether entry is permitted or not, entry permission requirements), thereby eliminating driver inconvenience and preventing the time required for entry from unnecessarily increasing.

Moreover, according to at least one of the embodiments of the present disclosure, when another facility is set as a new destination after entry into a specific facility, preemptive measures (for example, pre-discharging) may be taken to prevent the entry delay issue caused by high battery SOC when electric vehicle arrives at other facilities.

The effects of the present disclosure are not limited to the above-mentioned effects, and these and other effects will be clearly understood by those skilled in the art from the appended claims.

BRIEF DESCRIPTION OF THE DRAWINGS

The accompanying drawings illustrate the exemplary embodiments of the present disclosure and together with the following detailed description, serve to provide a better understanding of the technical aspects of the present disclosure, and thus the present disclosure should not be constructed as being limited to any of the drawings.

FIG. 1 is a diagram referenced in describing an electric vehicle according to the present disclosure.
FIG. 2 is a diagram schematically showing a configuration of a vehicle entry management apparatus according to an embodiment of the present disclosure.
FIG. 3 is a flowchart schematically showing a vehicle entry management method that may be performed by the vehicle entry management apparatus.
FIG. 4 is a diagram referenced in briefly describing an example of a vehicle entry management system including the vehicle entry management apparatus of FIG. 2.
FIG. 5 is a diagram referenced in briefly describing another example of a vehicle entry management system including the vehicle entry management apparatus of FIG. 2.
FIG. 6 is a diagram referenced in briefly describing still another example of a vehicle entry management system including the vehicle entry management apparatus of FIG. 2.
FIG. 7 is a diagram referenced in briefly describing yet another example of a vehicle entry management system including the vehicle entry management apparatus of FIG. 2.
FIGS. 8 and 9 are flowcharts schematically showing an example of a set of subroutines that may be included in a vehicle entry management operation according to step S320 of FIG. 3.
FIG. 10 is a diagram referenced in describing cell balancing.
FIG. 11 and FIG. 12 are diagrams referenced in describing exemplary information transmission and reception situations between an electric vehicle EV and a vehicle access controller 300 in the vehicle entry management system 1000 according to FIG. 4.
FIGS. 13 to 15 are diagrams referenced in describing exemplary information transmission and reception situations between an electric vehicle, a vehicle access controller and a remote server in the vehicle entry management system according to FIG. 5.
FIGS. 16 to 18 are diagrams referenced in describing exemplary information transmission and reception situations between an electric vehicle, a vehicle access controller and a mobile device in the vehicle entry management system according to FIG. 6.
FIGS. 19 to 22 are diagrams referenced in describing exemplary information transmission and reception situations between an electric vehicle, a vehicle access controller, a remote server and a mobile device in the vehicle entry management system according to FIG. 7.
FIG. 23 is a diagram referenced in describing a situation in which an electric vehicle entered a facility.
FIG. 24 is a flowchart schematically showing a vehicle entry management method according to another embodiment of the present disclosure.

BEST MODE

Hereafter, the exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure but not intended to be limiting, so it should be understood that a variety of other equivalents and modifications could be made thereto at the time the application was filed.

The terms including the ordinal numbers such as "first", "second" and the like, are used to distinguish one element from another among various elements, but not intended to limit the elements by the terms.

Unless the context clearly indicates otherwise, the terms "comprise" and "include" when used in this specification, specify the presence of the stated elements, but do not preclude the presence or addition of one or more other elements. Additionally, the term "unit" as used herein refers to a processing unit of at least one function or operation, and may be implemented by hardware and software either alone or in combination.

In addition, throughout this specification, it will be further understood that when an element is referred to as being "connected to" another element, it may be directly connected to the other element or intervening elements may be present.

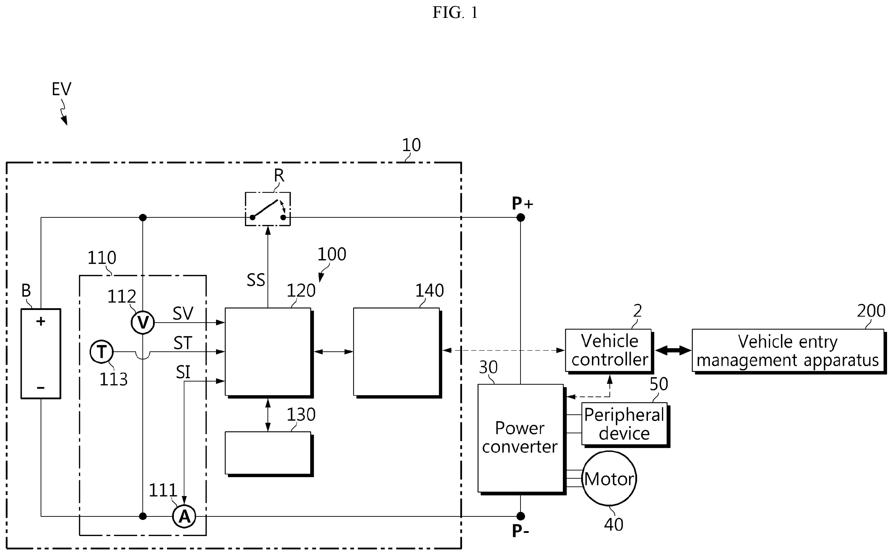

FIG. 1 is a diagram referenced in describing an electric vehicle according to the present disclosure.

Referring to FIG. 1, the electric vehicle EV includes a battery pack 10, a vehicle controller 2, a power converter 30 and a motor 40.

The battery pack 10 includes a battery B, a relay R and a battery management system 100.

The battery B includes at least one battery cell. Each battery cell may include, for example, a lithium-ion cell. The type of the battery cell is not limited to the lithium-ion cell, and is not limited to a particular one. The battery cell may include any type of battery cell that can be repeatedly charged and discharged. Each battery cell included in the battery B is electrically connected to other battery cell in series or in parallel.

The relay R is installed on a power path for the charge and discharge of the battery B. The relay R may have a control terminal that may be electrically connected to the battery management system 100. The relay R may be turned on and off in response to a switching signal SS from the battery management system 100 and/or the vehicle controller 2.

The vehicle controller 2 (for example, an Electronic Control Unit (ECU)) is configured to transmit a key-on signal to the battery management system 100 in response to a user's switching of the electric vehicle EV start button (not shown) to an ON position. The vehicle controller 2 is configured to transmit a key-off signal to the battery management system 100 in response to the user's switching of the start button to an OFF position.

The battery management system 100 includes a sensing unit 110 and a control unit 120. The battery management system 100 may further include a memory unit 130 and/or a communication unit 140.

The sensing unit 110 may periodically measure voltage, current and temperature of the battery B during charging and/or discharging of the battery B. The sensing unit 110 includes a current sensor 111, a voltage sensor 112 and a temperature sensor 113.

The current sensor 111 is electrically connected to a charge/discharge path of the battery B. The current sensor 111 is configured to output a signal SI indicating the magnitude and direction of the current flowing through the battery B to the control unit 120. For example, the current sensor 111 may include a shunt resistor and/or a Hall effect device.

The voltage sensor 112 may be electrically connected to positive and negative terminals of the battery B. The voltage sensor 112 is configured to detect a voltage across the positive terminal and the negative terminal of the battery B and output a signal SV indicating the detected voltage to the control unit 120.

The temperature sensor 113 is configured to detect a temperature of an area within a predetermined distance from the battery B and output a signal ST indicating the detected temperature to the control unit 120. For example, the temperature sensor 113 may include a negative temperature coefficient thermistor.

The control unit 120 is operably coupled to the sensing unit 110, the memory unit 130, the communication unit 140 and the relay R. The control unit 120 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors, or electrical units for performing other functions.

The control unit 120 may determine a current value, a voltage value and a temperature value from the signal SI, the signal SV and the signal ST, respectively, using an analog-to-digital converter (ADC), and store them in the memory unit 130.

The memory unit 130 is operably coupled to the control unit 120. The memory unit 130 may include at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). Although FIG. 1 shows that the memory unit 130 is separate from the control unit 120, the memory unit 130 may be embedded as the component of the control unit 120.

The control unit 120 may generate voltage time series data, current time series data, temperature time series data and/or state of charge (SOC) time series data during charging and discharging of the battery B based on the signals (SV, SI and/ or ST) collected from the sensing unit 110.

The communication unit 140 may be coupled to the vehicle controller 2 to enable communication between them. The communication unit 140 may transmit battery information of the battery B received from the control unit 120 to the vehicle controller 2. The communication unit 140 may communicate with the vehicle controller 2 via a wired network such as a local area network (LAN), a controller area network (CAN) or a daisy chain and/or a short-range wireless network such as Bluetooth, Zigbee or Wi-Fi.

The control unit 120 may determine the maximum capacity or state of health (SOH) of the battery B. The maximum capacity indicates the maximum amount of electric charge the battery B can store and may be referred to as 'full charge capacity'. For example, the maximum capacity is equal to the integral of the current that flows during discharging of the battery B with SOC 1 (=100%) until the SOC becomes 0 (=0%).

The control unit 120 may determine the SOH or maximum capacity of the battery B based on SOC at each of two different times and the integral of the current during the period of time between the two times using the following Equation 1. Of the two times, the earlier time is defined as $t_1$ and the later time is defined as $t_2$.

<Equation 1>

$$SOH_{new} = \frac{\int_{t1}^{t2} i_1 \, dt}{SOC_2 - SOC_1} = \frac{\Delta C}{\Delta SOC} = \frac{Q_{est}}{Q_{ref}}$$

In Equation 1, $Q_{ref}$ denotes a reference capacity, $SOC_1$ denotes an estimated SOC at time $t_1$, $SOC_2$ denotes an estimated SOC at time $t_2$, $\Delta SOC$ denotes a difference between $SOC_1$ and $SOC_2$, it denotes a current value indicating the current detected at time t between the time $t_1$ and the time $t_2$, $\Delta C$ denotes the integral of the current during the period of time from the time $t_1$ to the time $t_2$, $Q_{est}$ denotes an estimated maximum capacity at the time $t_2$, and $SOH_{new}$ denotes an estimated SOH at the time $t_2$. $Q_{ref}$ is a preset value indicating the maximum capacity when the SOH of the battery B is 1. $Q_{ref}$ may be referred to as 'design capacity' or 'initial full charge capacity', and be pre-stored in the memory unit 130.

The control unit 120 may periodically determine the SOC of the battery B during charging and/or discharging of the battery B based on the current value of the battery information using ampere counting (see Equation 2).

<Equation 2>

$$SOC[k+1] = SOC_e[k] + \frac{i[k+1]\Delta t}{Q_{est}}$$

The symbols used in Equation 2 are described as follows. $\Delta t$ may denote the measurement cycle (i.e., a time interval between two adjacent measurement timings) of a set of battery parameters including voltage, current and temperature. k may be a time index that increases by 1 as time passes by $\Delta t$.

The power converter 30 may include at least one of a direct current (DC)-alternating current (AC) converter or a DC-DC converter. The power converter 30 may convert DC power (discharge power) from the battery B into AC power and supply it to the motor 40 during discharging of the battery B. The motor 40 may include a three-phase AC motor that generates kinetic energy for the driving of the electric vehicle EV.

A peripheral device 50 may include vehicle sensor(s) to measure at least one parameter (for example, vehicle speed) related to the state of the electric vehicle EV. The peripheral device 50 may include an output device (for example, a display, a speaker) to provide the information received from the battery management system 100 and/or the vehicle controller 2 in a recognizable format. The peripheral device 50 may be driven using direct current or alternating current power supplied from the power converter 30. The peripheral device 50 may include a navigation device. The user of the electric vehicle EV may operate the navigation device to set a facility as a destination for the electric vehicle EV.

In this specification, the "facility" is not limited to a particular one and may include any building, structure or device having a sufficient space to accommodate the electric vehicle EV entering. Typical examples of the facility include underground parking lots in complexes or buildings, tower parking lots, outdoor parking lots or ships.

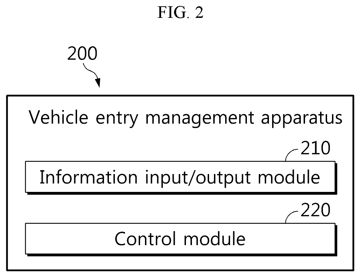

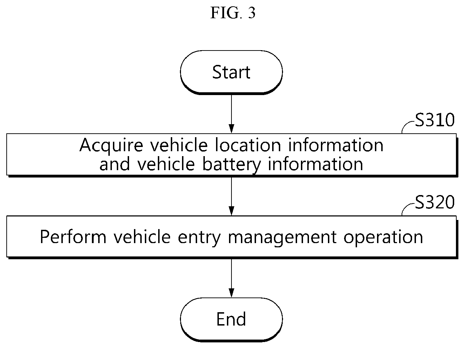

FIG. 2 is a diagram schematically showing a configuration of a vehicle entry management apparatus according to an embodiment of the present disclosure, and FIG. 3 is a flowchart schematically showing a vehicle entry management method that may be performed by the vehicle entry management apparatus. The method of FIG. 3 may be performed under the condition that the destination of the electric vehicle EV is set to a specific facility.

Referring to FIGS. 2 and 3, the vehicle entry management apparatus 200 may include an information input/output module 210 and a control module 220.

In step S310, the information input/output module 210 may acquire the vehicle location information and the vehicle battery information of the electric vehicle EV. The information input/output module 210 may acquire the vehicle location information and the vehicle battery information at the same time, or may acquire any one of the vehicle location information and the vehicle battery information and then the other. In this specification, acquiring information may refer to directly generating the information or receiving the information from another component.

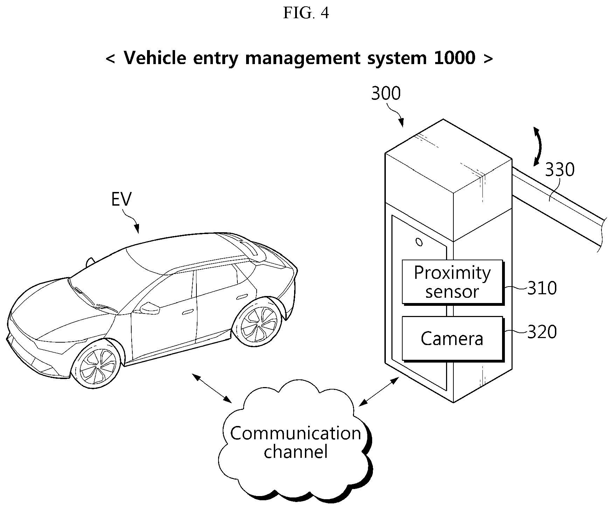

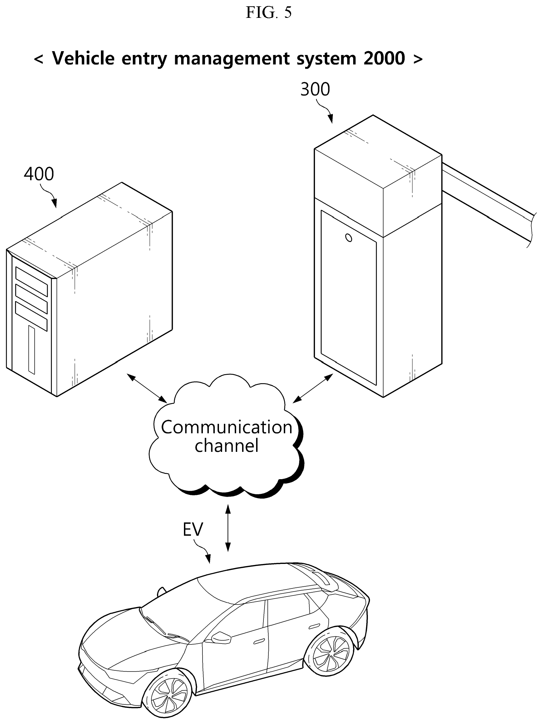

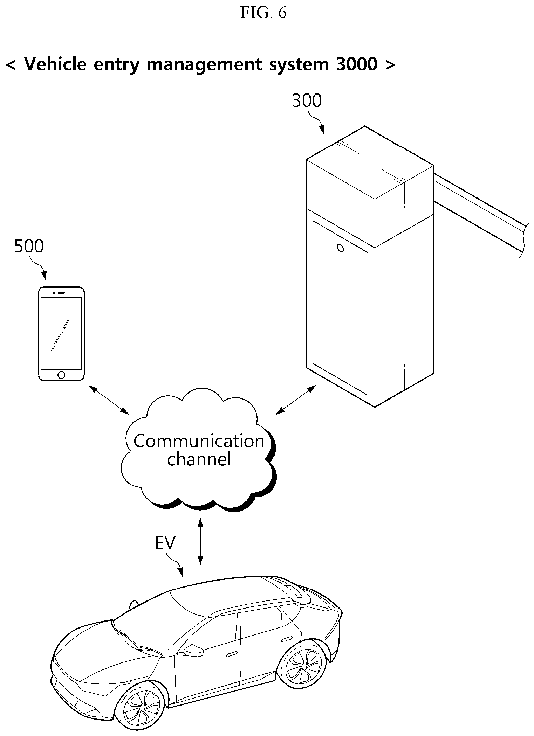

The information input/output module 210 may include a communication circuit. The communication circuit of the information input/output module 210 may be connected to the electric vehicle EV, a vehicle access controller 300 (in FIG. 4), a remote server 400 (in FIG. 5) and/or a mobile device 500 (in FIG. 6) through at least one wired communication channel and/or at least one wireless communication channel to enable communication between them to transmit and receive information to/from the electric vehicle EV, the vehicle access controller 300, the remote server 400 and/or the mobile device 500.

The vehicle location information may include information indicating a real-time location of the electric vehicle EV. The vehicle location information may include a vehicle image of the electric vehicle EV. The vehicle image may be a photographic image of at least a part (for example, a license plate) of the electric vehicle EV. The vehicle location information may include route guidance information from the electric vehicle EV to the facility. The route guidance information may include information indicating at least one recommended driving route to the facility, an expected arrival time of the electric vehicle EV for each recommended driving route to the facility, a remaining time until the expected arrival time and/or a remaining distance from the real-time location of the electric vehicle EV to the facility.

The vehicle battery information may include information indicating the battery SOC of the battery B in the electric vehicle EV. Instead of the battery SOC, the remaining charge capacity or available energy may be used. The vehicle battery information may include energy efficiency information of the electric vehicle EV. The energy efficiency information may indicate official energy efficiency and/or private energy efficiency of the electric vehicle EV. The private energy efficiency may refer to the average energy efficiency over the recent period (for example, one week).

The battery SOC included in the vehicle battery information may be referred to as "real-time battery SOC", "current battery SOC" or "current value of battery SOC". In comparison with this, the battery SOC at the time when the electric vehicle EV will arrive at the destination in the future may be referred to as "expected battery SOC" or "estimated battery SOC".

The information input/output module 210 may transmit the vehicle location information and the vehicle battery information of the electric vehicle EV to the control module 220.

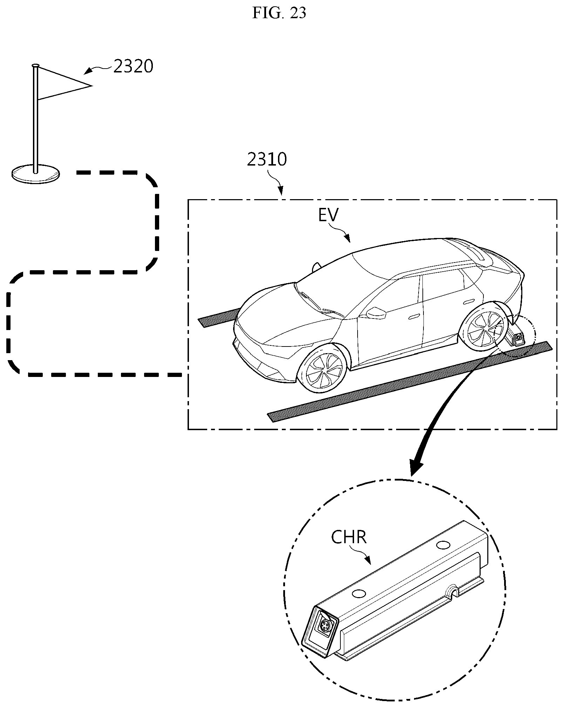

The control module 220 may perform a vehicle entry management operation related to the entry of the electric vehicle EV into the facility (see 2310 in FIG. 23) set as the current destination of the electric vehicle EV based on the vehicle location information and the vehicle battery information.

The control module 220 may be implemented in hardware using at least one of application specific integrated circuits (ASICs), digital signal processors (DSPs), digital signal processing devices (DSPDs), programmable logic devices (PLDs), field programmable gate arrays (FPGAs), microprocessors, or electrical units for performing other functions.

In step S320, the control module 220 performs the vehicle entry management operation related to the entry of the electric vehicle EV into the facility (for example, 2310 in FIG. 23) based on the vehicle location information and the vehicle battery information.

FIG. 4 is a diagram referenced in briefly describing an example of a vehicle entry management system including the vehicle entry management apparatus of FIG. 2.

Referring to FIG. 4, the vehicle entry management system 1000 may include the electric vehicle EV and the vehicle access controller 300. The vehicle entry management apparatus 200 may be included as the component of the vehicle access controller 300 or the electric vehicle EV.

The vehicle access controller 300 may be installed at the entrance of the facility set as the current destination of the electric vehicle EV. The vehicle access controller 300 may be configured to make wired and/or wireless communication with the electric vehicle EV.

The vehicle access controller 300 may include a proximity sensor 310 and/or a camera 320.

The proximity sensor 310 may detect the presence of an object moving within a predetermined distance from the entrance of the facility. When the object is detected by the proximity sensor 310, the image capturing function of the camera 320 may be activated. Accordingly, the object detected by the proximity sensor 310 may be found in the image captured by the camera 320.

When the object detected by the proximity sensor 310 is the electric vehicle EV, the captured image may be referred to as the vehicle image. The vehicle location information may include the image captured by the camera 320 and/or its image processing result data (for example, vehicle number).

The vehicle access controller 300 may control a barrier gate 330 into a closed or open state in response to a gate opening request from the electric vehicle EV and/or the vehicle entry management apparatus 200. The barrier gate 330 may include any one of a bar type, a rod type or a door type or a combination of two or more thereof.

While the barrier gate 330 is closed, the path connected to the entrance of the facility may be blocked by the barrier gate 330 to prohibit the entry of the electric vehicle EV. In contrast, while the barrier gate 330 is open, entry into the facility is permitted. FIG. 1 shows the barrier gate 330 in the closed state.

Information indicating the set destination on a navigation device may be shared between the electric vehicle EV and the vehicle access controller 300 via wired communication and/or wireless communication.

The control module 220 may determine whether the electric vehicle EV has arrived at the facility based on the vehicle location information. In other words, the control module 220 may determine whether the electric vehicle EV is attempting to enter the facility.

When it is determined that the electric vehicle EV has arrived at the facility, the control module 220 may determine whether to allow or disallow the entry of the electric vehicle EV into the facility. When the entry of the electric vehicle EV is determined to be disallowed, the control module 220 may perform an operation of disallowing the entry of the electric vehicle EV into the facility. When the entry of the electric vehicle EV is determined to be allowed, the control module 220 may perform an operation of allowing the entry of the electric vehicle EV into the facility.

The electric vehicle EV or the vehicle access controller 300 may determine an expected SOC reduction for each recommended driving route based on the vehicle location information. The expected SOC reduction associated with a driving route may indicate an estimated reduction in the battery SOC of the battery B when the electric vehicle EV drives along the driving route until arrival at the facility.

The expected SOC reduction may be determined based on the energy efficiency (for example, official energy efficiency, average energy efficiency over the recent period) and the remaining distance of the electric vehicle. Here, the energy efficiency, the remaining distance and the expected SOC reduction may have a predetermined correlation relationship. For example, those skilled in the art will readily understand that as the energy efficiency is lower and the remaining distance is longer, the expected SOC reduction will increase.

In this specification, scenario #1 may refer to an embodiment in which the vehicle entry management apparatus 200 is included in the electric vehicle EV, and scenario #2 may refer to an embodiment in which the vehicle entry management apparatus 200 is included in the vehicle access controller 300.

### <Scenario #1 of the vehicle entry management system 1000>

First, scenario #1 of the vehicle entry management system 1000 will be described. In scenario #1, the vehicle entry management apparatus 200 may be detachably provided to the electric vehicle EV. For example, the vehicle entry management apparatus 200 may be configured to act as an on-board diagnostics (OBD) system for the electric vehicle EV.

The information input/output module 210 may acquire the vehicle location information and the vehicle battery information directly from the battery management system 100 and/or the vehicle controller 2. The control module 220 may generate the gate opening request for the vehicle access controller 300 based on the vehicle location information and the vehicle battery information. The information input/output module 210 may transmit the gate opening request generated by the control module 220 to the vehicle access controller 300.

### <Scenario #2 of the vehicle entry management system 1000>

Subsequently, scenario #2 of the vehicle entry management system 1000 will be described. In scenario #2, the information input/output module 210 may acquire the vehicle image (or its image processing result) and/or a code image (or its image processing result) as the vehicle location information from the proximity sensor 310 and/or the camera 320.

The information input/output module 210 may receive the vehicle battery information from the electric vehicle EV, and further receive additional information related to the electric vehicle EV such as vehicle identification information (for example, vehicle number, driver, owner).

The control module 220 may determine whether the electric vehicle EV has arrived at the facility based on the vehicle location information. When the electric vehicle EV is not detected by the vehicle access controller 300, the barrier gate 330 may be kept in the closed state.

The control module 220 may perform image processing (for example, license plate recognition) of the image captured by the camera 320 to determine whether the electric vehicle EV has arrived at the facility. The vehicle image may include an image of the license plate of the electric vehicle EV and/or a code image of a QR code (which records the vehicle identification information) attached to the electric vehicle EV. The control module 220 may record the vehicle identification information recognized through the image processing of the vehicle image in the memory. The vehicle number may be used to determine whether the electric vehicle EV has the right to enter the facility. The vehicle number is an example of the vehicle identification information, and the vehicle identification information is not limited to the vehicle number. For example, the vehicle identification information may include a vehicle registration number or user identification information (for example, the driver or owner's personal information).

When it is determined that the electric vehicle EV has arrived at the facility, the information input/output module 210 may request the vehicle battery information from the electric vehicle EV and receive the vehicle battery information from the electric vehicle EV.

The receipt of the vehicle battery information by the information input/output module 210 may indicate that the electric vehicle EV has arrived at the facility. Accordingly, the control module 220 may generate a control request or control command for the vehicle access controller 300 based on the vehicle battery information. The information input/output module 210 may transmit the control request or control command generated by the control module 220 to the vehicle access controller 300.

FIG. 5 is a diagram referenced in briefly describing another example of the vehicle entry management system including the vehicle entry management apparatus of FIG. 2.

Referring to FIG. 5, the vehicle entry management system 2000 is different from the vehicle entry management system shown in FIG. 4 in that it includes the electric vehicle EV and the vehicle access controller 300, and further includes the remote server 400. In describing the vehicle entry management system 2000 below, to avoid redundancy, the description that is shared between the vehicle entry management system 2000 and the vehicle entry management system 1000 may be omitted.

The vehicle entry management apparatus 200 may be included as the component of the electric vehicle EV, the vehicle access controller 300 or the remote server 400.

The information indicating the destination on the navigation device may be shared between the electric vehicle EV, the vehicle access controller 300 and the remote server 400 via wired communication and/or wireless communication.

The information input/output module 210 may be connected to the electric vehicle EV, the vehicle access controller 300 and/or the remote server 400 through the wired communication channel and/or the wireless communication channel to receive the vehicle location information and/or the vehicle battery information from the electric vehicle EV, the vehicle access controller 300 and/or the remote server 400.

The electric vehicle EV, the vehicle access controller 300 and/or the remote server 400 may determine the expected SOC reduction for each recommended driving route based on the vehicle location information.

### <Scenario #1 of the vehicle entry management system 2000>

Scenario #1 of the vehicle entry management system 2000 may have some description in common with scenario #1 of the vehicle entry management system 1000.

The control module 220 may determine that the electric vehicle EV has arrived at the facility when communication connection on the wireless communication channel between the information input/output module 210 and the vehicle access controller 300 is established. The wireless communication channel may include, for example, Bluetooth, RFID, Zigbee, NFC, LTE, 5G or Wi-Fi.

The remote server 400 may periodically or aperiodically collect the vehicle location information and/or the vehicle battery information from the information input/output module 210.

The control module 220 and/or the remote server 400 may identify the remaining distance between the electric vehicle EV and the facility based on the vehicle location information. When the identified remaining distance is equal to or shorter than a reference distance (for example, preset to 5 m), the control module 220 and/or the remote server 400 may determine that the electric vehicle EV has arrived at the facility. In contrast, when the identified remaining distance is longer than the reference distance, the control module 220 and/or the remote server 400 may determine that the electric vehicle EV has not yet arrived at the facility.

When it is determined that the electric vehicle EV has arrived at the facility, the control module 220 may determine whether allow or disallow the entry of the electric vehicle EV into the facility based on the vehicle battery information.

When the entry of the electric vehicle EV is permitted, the control module 220 may control the information input/output module 210 to transmit the request (the gate opening request) for switching the barrier gate 330 of the vehicle access controller 300 to the open state to the vehicle access controller 300 or the remote server 400. For example, the gate opening request may be transmitted directly from the information input/output module 210 to the vehicle access controller 300 or may be transmitted from the information input/output module 210 to the vehicle access controller 300 via the remote server 400.

### <Scenario #2 of the vehicle entry management system 2000>

Scenario #2 of the vehicle entry management system 2000 may have some description in common with scenario #2 of the vehicle entry management system 1000.

The remote server 400 may periodically or aperiodically collect the vehicle location information and/or the vehicle battery information from the information input/output module 210.

The control module 220 may determine that the electric vehicle EV has arrived at the facility when communication connection on the wireless communication channel between the information input/output module 210 and the electric vehicle EV is established.

The information input/output module 210 may receive the vehicle identification information of the electric vehicle EV from the electric vehicle EV and/or the remote server 400.

The control module 220 may check the vehicle identification information of the electric vehicle EV from the remote server 400 to identify whether the electric vehicle EV has the right to enter the facility.

When it is determined that the electric vehicle EV has arrived at the facility, the control module 220 and/or the remote server 400 may determine whether to allow or disallow the entry of the electric vehicle EV into the facility based on the vehicle battery information.

When the entry of the electric vehicle EV is permitted, the control module 220 may switch the barrier gate 330 of the vehicle access controller 300 to the open state.

### <Scenario #3 of the vehicle entry management system 2000>

In this specification, scenario #3 may refer to an embodiment in which the vehicle entry management apparatus 200 is included in the remote server 400.

The information input/output module 210 may acquire the vehicle location information and/or the vehicle battery information from the electric vehicle EV and/or the vehicle access controller 300 through the wireless communication channel.

The information input/output module 210 may determine whether the electric vehicle EV has arrived at the facility based on the vehicle location information.

As an example, the information input/output module 210 may determine that the electric vehicle EV has arrived at the facility when the vehicle location information acquired from the vehicle access controller 300 includes the vehicle image and/or the code image of the electric vehicle EV.

As another example, the information input/output module 210 may determine that the electric vehicle EV has arrived at the facility when the remaining distance indicated by the vehicle location information acquired from the electric vehicle EV is equal to or shorter than the reference distance.

As still another example, the information input/output module 210 may determine that the electric vehicle EV has arrived at the facility when the vehicle location information acquired from the vehicle access controller 300 includes the vehicle image and/or the code image of the electric vehicle EV and the remaining distance indicated by the vehicle location information acquired from the electric vehicle EV is equal to or shorter than the reference distance.

The information input/output module 210 may receive the vehicle battery information from the electric vehicle EV and further receive additional information related to the electric vehicle EV such as the vehicle identification information.

When it is determined that the electric vehicle EV has arrived at the facility, the control module 220 may determine whether to allow or disallow the entry of the electric vehicle EV into the facility based on the vehicle battery information.

When it is determined that entry of the electric vehicle EV is permitted, the control module 220 may control the information input/output module 210 to transmit the gate opening request for switching the barrier gate 330 of the vehicle access controller 300 to the open state to the vehicle access controller 300. For example, the gate opening request may be transmitted directly from the information input/output module 210 to the vehicle access controller 300 or may be transmitted from the information input/output module 210 to the vehicle access controller 300 via the electric vehicle EV.

FIG. 6 is a diagram referenced in briefly describing still another example of the vehicle entry management system including the vehicle entry management apparatus of FIG. 2.

Referring to FIG. 6, the vehicle entry management system 3000 is different from the vehicle entry management system 1000 shown in FIG. 3 and the vehicle entry management system 2000 shown in FIG. 4 in that it includes the electric vehicle EV and the vehicle access controller 300 and further includes the mobile device 500. In describing the vehicle entry management system 3000 below, to avoid redundancy, the description that is shared between the vehicle entry management system 3000 and the vehicle entry management system 1000 or the vehicle entry management system 2000 may be omitted.

The vehicle entry management apparatus 200 may be included as the component of the electric vehicle EV, the vehicle access controller 300 or the mobile device 500.

The information input/output module 210 may be connected to the electric vehicle EV, the vehicle access controller 300 and/or the mobile device 500 through the wired communication channel and/or the wireless communication channel to enable communication between them to receive the vehicle location information and/or the vehicle battery information from the electric vehicle EV, the vehicle access controller 300 and/or the mobile device 500.

The information indicating the destination set on the navigation device or the mobile device 500 may be shared between at least two of the electric vehicle EV, the vehicle access controller 300 or the mobile device 500 via wired communication and/or wireless communication.

The electric vehicle EV, the vehicle access controller 300 or the mobile device 500 may determine the expected SOC reduction for each recommended driving route based on the vehicle location information.

**<Scenario #1 of the vehicle entry management system 3000>**

Scenario #1 of the vehicle entry management system 3000 may have some description in common with scenario #1 of the vehicle entry management system 1000 and/or the vehicle entry management system 2000.

The control module 220 may determine that the electric vehicle EV has arrived at the facility when communication connection on the wireless communication channel between the information input/output module 210 and the vehicle access controller 300 is established.

The mobile device 500 may periodically or aperiodically collect the vehicle location information and/or the vehicle battery information from the information input/output module 210.

The control module 220 and/or the mobile device 500 may determine that the electric vehicle EV has arrived at the facility when the remaining distance between the electric vehicle EV and the facility indicated by the vehicle location information is equal to or shorter than the reference distance, and otherwise, may determine that the electric vehicle EV has not yet arrived at the facility.

When it is determined that the electric vehicle EV has arrived at the facility, the control module 220 may determine whether to allow or disallow the entry of the electric vehicle EV into the facility based on the vehicle battery information.

When it is determined that the entry of the electric vehicle EV is permitted, the control module 220 may control the information input/output module 210 to transmit the gate opening request to the vehicle access controller 300 or the mobile device 500.

**<Scenario #2 of the vehicle entry management system 3000>**

Scenario #2 of the vehicle entry management system 3000 may have some description in common with scenario #2 of the vehicle entry management system 1000 and/or the vehicle entry management system 2000.

The mobile device 500 may periodically or aperiodically collect the vehicle location information and/or the vehicle battery information from the information input/output module 210.

The control module 220 may determine that the electric vehicle EV has arrived at the facility when communication connection on the wireless communication channel between the information input/output module 210 and the electric vehicle EV is established.

The control module 220 may determine that the electric vehicle EV has arrived at the facility when the vehicle location information acquired by the information input/output module 210 includes the vehicle image and/or the code image of the electric vehicle EV.

The information input/output module 210 may receive the vehicle identification information of the electric vehicle EV from the electric vehicle EV and/or the mobile device 500.

The control module 220 may check the vehicle identification information of the electric vehicle EV from the electric vehicle EV and/or the mobile device 500 to identify whether the electric vehicle EV has the right to enter the facility.

The vehicle battery information may be transmitted directly from the electric vehicle EV to the vehicle access controller 300. Alternatively, the vehicle battery information may be transmitted from the electric vehicle EV to the vehicle access controller 300 through the mobile device 500.

When it is determined that the electric vehicle EV has arrived at the facility, the control module 220 and/or the mobile device 500 may determine whether to allow or disallow the entry of the electric vehicle EV into the facility based on the vehicle battery information.

When it is determined that the entry of the electric vehicle EV is permitted, the control module 220 may switch the barrier gate 330 of the vehicle access controller 300 to the open state.

**<Scenario #4 of the vehicle entry management system 3000>**

In this specification, scenario #4 may refer to an embodiment in which the vehicle entry management apparatus 200 is included in the mobile device 500.

The information input/output module 210 may acquire the vehicle location information and/or the vehicle battery information from the electric vehicle EV and/or the vehicle access controller 300 through the wireless communication channel.

The information input/output module 210 may determine whether the electric vehicle EV has arrived at the facility based on the vehicle location information.

As an example, the information input/output module 210 may determine that the electric vehicle EV has arrived at the facility when the vehicle location information acquired from the vehicle access controller 300 includes the vehicle image and/or the code image of the electric vehicle EV.

As another example, the information input/output module 210 may determine that the electric vehicle EV has arrived at the facility when the remaining distance indicated by the vehicle location information acquired from the electric vehicle EV is equal to or shorter than the reference distance.

As still another example, the information input/output module 210 may determine that the electric vehicle EV has arrived at the facility when the vehicle location information acquired from the vehicle access controller 300 includes the vehicle image and/or the code image of the electric vehicle EV and the remaining distance indicated by the vehicle location information acquired from the electric vehicle EV is equal to or shorter than the reference distance.

The information input/output module 210 may receive the vehicle battery information from the electric vehicle EV and further receive additional information related to the electric vehicle EV such as the vehicle identification information.

When it is determined that the electric vehicle EV has arrived at the facility, the control module 220 may determine whether to allow or disallow the entry of the electric vehicle EV into the facility based on the vehicle battery information.

When it is determined that the entry of the electric vehicle EV is permitted, the control module 220 may control the information input/output module 210 to transmit the gate opening request to the vehicle access controller 300. For example, the gate opening request may be transmitted directly from the information input/output module 210 to the vehicle access controller 300, or may be transmitted from the information input/output module 210 to the vehicle access controller 300 via the electric vehicle EV.

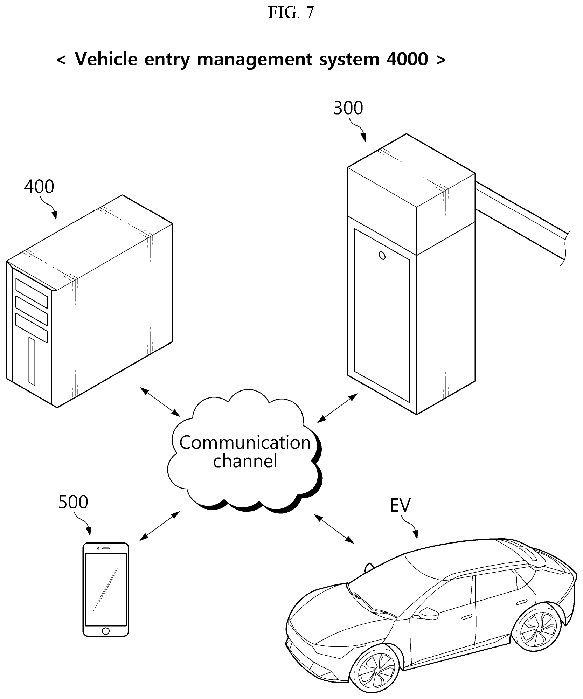

FIG. 7 is a diagram referenced in briefly describing yet another example of the vehicle entry management system including the vehicle entry management apparatus of FIG. 2.

Referring to FIG. 7, the vehicle entry management system 4000 is different from the vehicle entry management systems 1000, 2000, 3000 shown in FIGS. 4 to 6 in that it includes the electric vehicle EV and the vehicle access controller 300, and further includes the remote server 400 and the mobile device 500. In describing the vehicle entry management system 4000 below, to avoid redundancy, the description that is shared between the vehicle entry management system 4000 and the vehicle entry management systems 1000, 2000, 3000 may be omitted.

The vehicle entry management apparatus 200 may be included as the component of the electric vehicle EV, the vehicle access controller 300, the remote server 400 or the mobile device 500.

The remote server 400 may support the functions of a vehicle management application installed on the mobile device 500. At least two of the electric vehicle EV, the vehicle access controller 300, the remote server 400 or the mobile device 500 may exchange data with each other. For example, the remote server 400 may perform at least one function in response to a request from the mobile device 500 and transmit the result data to the mobile device 500.

The information input/output module 210 may be connected to the electric vehicle EV, the vehicle access controller 300, the remote server 400 and/or the mobile device 500 through the wired communication channel and/or the wireless communication channel to enable communication between them to receive the vehicle location information and/or the vehicle battery information from the electric vehicle EV, the vehicle access controller 300, the remote server 400 and/or the mobile device 500.

The information indicating the destination set on the navigation device or the mobile device 500 may be shared between at least two of the electric vehicle EV, the vehicle access controller 300, the remote server 400 or the mobile device 500 via wired communication and/or wireless communication.

The vehicle location information and/or the vehicle battery information may be shared between at least two of the electric vehicle EV, the vehicle access controller 300, the remote server 400 or the mobile device 500.

The electric vehicle EV, the vehicle access controller 300, the remote server 400 or the mobile device 500 may determine the expected SOC reduction for each recommended driving route based on the vehicle location information.

**<Scenario #1 of the vehicle entry management system 4000>**

Scenario #1 of the vehicle entry management system 4000 may have some description in common with scenario #1 of the vehicle entry management system 1000, the vehicle entry management system 2000 and/or the vehicle entry management system 3000.

The vehicle access controller 300, the remote server 400 and/or the mobile device 500 may periodically or aperiodically collect the vehicle location information and/or the vehicle battery information from the information input/output module 210.

The information input/output module 210 and the mobile device 500 may be connected to enable communication through the short-range wireless communication channel (for example, Bluetooth), and the mobile device 500 and the remote server 400 may be connected to enable communication through the long-range wireless communication channel (for example, Wi-Fi, LTE).

The information input/output module 210 may receive the vehicle location information and/or the vehicle battery information from the battery management system 100 and/or the vehicle controller 2 through the wired communication channel (for example, Controller Area Network (CAN)). The information input/output module 210 may transmit the vehicle location information and/or the vehicle battery information to the vehicle access controller 300 and/or the remote server 400 using the long-distance communication channel provided by the mobile device 500.

The remote server 400 may transmit the information indicating the expected SOC reduction of the battery SOC for each recommended driving route to the vehicle access controller 300 and/or the mobile device 500. The mobile device 500 may transmit the information indicating the expected SOC reduction of the battery SOC for each recommended driving route to the information input/output module 210 through the short-range wireless communication channel.

The control module 220 may determine that the electric vehicle EV has arrived at the facility when communication connection on the wireless communication channel between the information input/output module 210 and the vehicle access controller 300 is established.

The control module 220, the vehicle access controller 300, the remote server 400 and/or the mobile device 500 may determine that the electric vehicle EV has arrived at the facility when the remaining distance between the electric vehicle EV and the facility indicated by the vehicle location information is equal to or shorter than the reference distance, and otherwise, may determine that the electric vehicle EV has not yet arrived at the facility.

When it is determined that the electric vehicle EV has arrived at the facility, the control module 220 may determine whether to allow or disallow the entry of the electric vehicle EV into the facility based on the vehicle battery information.

When it is determined that the entry of the electric vehicle EV is permitted, the control module 220 may control the information input/output module 210 to transmit the gate opening request to the vehicle access controller 300, the remote server 400 or the mobile device 500.

**<Scenario #2 of the vehicle entry management system 4000>**

Scenario #2 of the vehicle entry management system 4000 may have some description in common with scenario #2 of the vehicle entry management system 1000, the vehicle entry management system 2000 and/or the vehicle entry management system 3000.

The remote server 400 and/or the mobile device 500 may periodically or aperiodically collect the vehicle location information and/or the vehicle battery information from the information input/output module 210.

The control module 220 may determine that the electric vehicle EV has arrived at the facility when communication connection on the wireless communication channel between the information input/output module 210 and the electric vehicle EV is established.

The control module 220 may determine that the electric vehicle EV has arrived at the facility when the vehicle location information acquired by the information input/output module 210 includes the vehicle image and/or the code image of the electric vehicle EV.

The information input/output module 210 may receive the vehicle identification information of the electric vehicle EV from the electric vehicle EV and/or the mobile device 500.

The control module 220 may check the vehicle identification information of the electric vehicle EV from the electric vehicle EV and/or the mobile device 500 to identify whether the electric vehicle EV has the right to enter the facility.

The vehicle battery information may be transmitted directly from the electric vehicle EV to the vehicle access controller 300. Alternatively, the vehicle battery information may be transmitted from the electric vehicle EV to the vehicle access controller 300 through the remote server 400 or the mobile device 500.

When it is determined that the electric vehicle EV has arrived at the facility, the control module 220, the remote server 400 and/or the mobile device 500 may determine whether to allow or disallow the entry of the electric vehicle EV into the facility based on the vehicle battery information.

When it is determined that the entry of the electric vehicle EV is permitted, the control module 220 may switch the barrier gate 330 of the vehicle access controller 300 to the open state.

**<Scenario #3 of the vehicle entry management system 4000>**

The information input/output module 210 may acquire the vehicle location information and/or the vehicle battery information from the electric vehicle EV, the vehicle access controller 300 and/or the mobile device 500 through the wireless communication channel.

The information input/output module 210 may determine whether the electric vehicle EV has arrived at the facility based on the vehicle location information.

As an example, the information input/output module 210 may determine that the electric vehicle EV has arrived at the facility when the vehicle location information acquired from the electric vehicle EV, the vehicle access controller 300 or the mobile device 500 includes the vehicle image and/or the code image of the electric vehicle EV.

As another example, the information input/output module 210 may determine that the electric vehicle EV has arrived at the facility when the remaining distance indicated by the vehicle location information is equal to or shorter than the reference distance.

As still another example, the information input/output module 210 may determine that the electric vehicle EV has arrived at the facility when the vehicle location information includes the vehicle image and/or the code image of the electric vehicle EV and the remaining distance indicated by the vehicle location information is equal to or shorter than the reference distance.

The information input/output module 210 may receive the vehicle battery information from the electric vehicle EV and/or the mobile device 500, and further receive additional information related to the electric vehicle EV such as the vehicle identification information.

When it is determined that the electric vehicle EV has arrived at the facility, the control module 220 may determine whether to allow or disallow the entry of the electric vehicle EV into the facility based on the vehicle battery information.

When it is determined that the entry of the electric vehicle EV is permitted, the control module 220 may control the information input/output module 210 to transmit the gate opening request to the electric vehicle EV, the vehicle access controller 300 and/or the mobile device 500. For example, the gate opening request may be transmitted directly from the information input/output module 210 to the vehicle access controller 300, or may be transmitted from the information input/output module 210 to the vehicle access controller 300 via the electric vehicle EV or the mobile device 500.

**<Scenario #4 of the vehicle entry management system 4000>**

The information input/output module 210 may acquire the vehicle location information and/or the vehicle battery information from the electric vehicle EV, the vehicle access controller 300 and/or the remote server 400 through the wireless communication channel. For example, the information input/output module 210 may transmit the vehicle battery information directly received from the battery management system 100 of the electric vehicle EV to the remote server 400. The remote server 400 may transmit the vehicle battery information received from the information input/output module 210 to the vehicle access controller 300.

The information input/output module 210 may determine whether the electric vehicle EV has arrived at the facility based on the vehicle location information.

The information input/output module 210 may receive the vehicle battery information from the electric vehicle EV, the vehicle access controller 300 and/or the remote server 400, and further receive additional information related to the electric vehicle EV such as the vehicle identification information.

When it is determined that the electric vehicle EV has arrived at the facility, the control module 220 may determine whether to allow or disallow the entry of the electric vehicle EV into the facility based on the vehicle battery information.

When it is determined that the entry of the electric vehicle EV is permitted, the control module 220 may control the information input/output module 210 to transmit the gate opening request to the electric vehicle EV, the vehicle access controller 300 and/or the remote server 400. As an example, the gate opening request may be directly transmitted from the information input/output module 210 to the vehicle access controller 300. As another example, the gate opening request may be transmitted from the information input/output module 210 to the vehicle access controller 300 via the electric vehicle EV or the remote server 400.

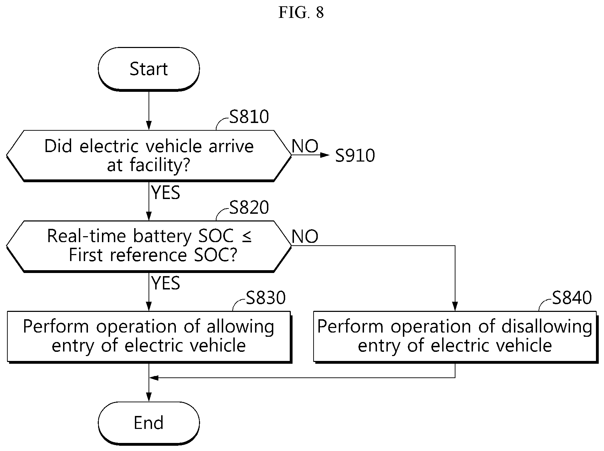

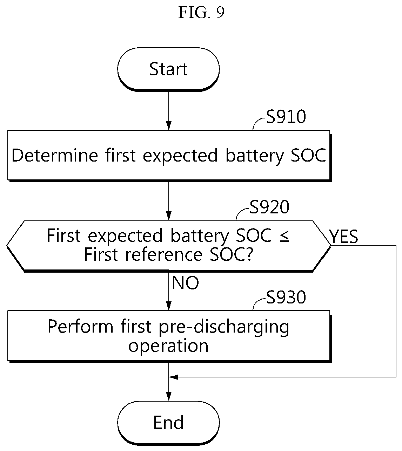

FIGS. 8 and 9 are flowcharts schematically showing an example of a set of subroutines that may be included in the vehicle entry management operation according to the step S320 of FIG. 3. The method of FIGS. 8 and 9 may be applied to at least one of the vehicle entry management systems 1000, 2000, 3000, 4000 described above with reference to FIGS. 4 to 7.

Referring to FIG. 8, in step S810, the control module 220 determines whether the electric vehicle EV has arrived at the facility based on the vehicle location information acquired in the step S310. When a value of the step S810 is "YES", step S820 may be performed. The value of the step S810 being "NO" may represent that the electric vehicle EV is driving toward the facility. When the value of the step S810 is "NO", the method of FIG. 8 may end, or the method of FIG. 9 may be performed.

In the step S820, the control module 220 determines whether the real-time battery SOC is equal to or less than a first reference SOC based on the vehicle battery information. The first reference SOC is the criterion for entry permission into the facility at which the electric vehicle EV has arrived, and may be a preset value, for example, 85% or 90%. The first reference SOC may be pre-stored in the memory of the control module 220. Alternatively, the first reference SOC may be shared between at least two of the electric vehicle EV, the vehicle access controller 300, the remote server 400 or the mobile device 500. For example, the passenger of the electric vehicle EV may input a desired first reference SOC value into the mobile device 500, and the passenger's first reference SOC input to the mobile device 500 may be transmitted from the mobile device 500 to the vehicle entry management apparatus 200. When a value of the step S820 is "YES", step S830 may be performed. When the value of the step S820 is "NO", step S840 may be performed.

In the step S830, the control module 220 may perform an operation of allowing the entry of the electric vehicle EV.

The operation of allowing the entry may include a function of transmitting an allowed entry notification to the electric vehicle EV and/or the mobile device 500. The operation of allowing the entry may include a function of controlling the barrier gate 330 to the open state.

In scenario #1, the control module 220 may control the peripheral device 50 to output a text and/or voice notifying the allowed entry to the passenger of the electric vehicle EV.

In scenario #2, scenario #3 and/or scenario #4, the control module 220 may control the information input/output module 210 to transmit a message notifying the allowed entry to the electric vehicle EV.

In scenario #1, scenario #3 and/or scenario #4, the control module 220 may control the information input/output module 210 to transmit a control signal that requests to switch the barrier gate 330 to the open state to the vehicle access controller 300.

In scenario #2, the control module 220 may directly control the barrier gate 330 into the open state.

In the step S840, the control module 220 may perform an operation of disallowing the entry of the electric vehicle EV. The operation of disallowing the entry may include a function of transmitting a disallowed entry notification to the electric vehicle EV and/or the mobile device 500. The operation of disallowing the entry may include a function of controlling the barrier gate 330 into the closed state.

In scenario #1, the control module 220 may control the peripheral device 50 to output a text and/or voice notifying the disallowed entry to the passenger of the electric vehicle EV.

In scenario #2, scenario #3 and/or scenario #4, the control module 220 may control the information input/output module 210 to transmit a message notifying the disallowed entry to the electric vehicle EV.

In scenario #1, scenario #3 and/or scenario #4, the control module 220 may control the information input/output module 210 to transmit a control signal that requests to keep the gate 330 in the closed state to the vehicle access controller 300.

In scenario #2, the control module 220 may directly keep the barrier gate 330 in the closed state.

Referring to FIG. 9, step S910 may be performed when it is determined in the step S810 that the electric vehicle EV has not yet arrived at the facility. In the step S910, the control module 220 determines a first expected battery SOC of the electric vehicle EV based on the vehicle location information and the vehicle battery information. The first expected battery SOC may refer to a battery SOC of the battery B at the time when the electric vehicle EV is expected to arrive at the facility along a main driving route along which the electric vehicle EV is currently driving. The main driving route may refer to a driving route along which the electric vehicle EV is currently driving.

The first expected battery SOC may be a value obtained by subtracting the expected SOC reduction for the main driving route to the facility 3110 (in FIG. 23) from the real-time battery SOC. An SOC estimation model may be used to determine the expected SOC reduction for the driving route. The SOC estimation model may include a single mathematical function or a combination of two or more mathematical functions.

The SOC estimation model may be stored in the control module 220, the remote server 400 and/or the mobile device 500. When input information including real-time battery SOC and a specific driving route is inputted into the SOC estimation model, the SOC estimation model may output the expected battery SOC at the time of arrival at the facility along the specific driving route.

When the SOC estimation model is stored in the control module 220, the control module 220 may directly determine the expected SOC reduction. The control module 220 may determine the first expected battery SOC by subtracting the expected SOC reduction determined for the main driving route from the real-time battery SOC.

Alternatively, when the SOC estimation model is stored in the remote server 400 or the mobile device 500, the remote server 400 or the mobile device 500 may transmit the expected SOC reduction determined using the SOC estimation model to the vehicle entry management apparatus 200. The control module 220 may determine the first expected battery SOC by subtracting the expected SOC reduction notified from the remote server 400 or the mobile device 500 from the real-time battery SOC.

In step S920, the control module 220 determines whether the first expected battery SOC is equal to or less than the first reference SOC. When a value of the step S920 is "YES", the method according to FIG. 9 may end. When the value of the step S920 is "NO", step S930 may be performed.

In the step S930, the control module 220 performs a first pre-discharging operation for the electric vehicle EV. The first pre-discharging operation may include at least one function for increasing the energy consumption of the battery B during the remaining time until the electric vehicle EV arrives at the facility to reduce the first expected battery SOC below the first reference SOC. The first pre-discharging operation (referred to as "pre-entry discharging operation") that is performed before the entry at the facility is distinguished from a second pre-discharging operation that may be performed after the entry at the facility.

Information related to the first expected battery SOC, the first reference SOC, the SOC difference and/or the first pre-discharging operation based on them may be provided to the passenger of the electric vehicle EV through the peripheral device 50 and/or the mobile device 500. The passenger of the electric vehicle EV may input a target battery SOC that is equal to or less than the first reference SOC by manipulating a user input unit (for example, a touch panel, a button) of the peripheral device 50 and/or the mobile device 500. The target SOC may refer to a battery SOC at the expected arrival time desired by the passenger of the electric vehicle EV. For example, when the first expected battery SOC = 93% and the first reference SOC = 90%, the passenger may input the target SOC of 85%. The target SOC input to the peripheral device 50 and/or the mobile device 500 may be transmitted to the information input/output module 210. In this case, the control module 220 may perform the first pre-discharging operation based on the SOC difference between the first expected battery SOC and the target SOC, instead of the SOC difference between the first expected battery SOC and the first reference SOC.

The first pre-discharging operation may include a function of changing the driving route of the electric vehicle EV. The control module 220 may change the main driving route guided by the navigation device and/or the mobile device 500 to another driving route based on the SOC difference between the first expected battery SOC and the first reference SOC (or the target SOC). The expected SOC reduction of the battery SOC for the changed driving route may be larger than the expected SOC reduction for the main driving route by the SOC difference or more.

The route guidance information may include at least one recommended route to the destination (facility) and additional information for each recommended route. For example, the additional information for each recommended route may include various data that defines the characteristics of the recommended route such as remaining distance, remaining time, road type (for example, expressway, toll-free road), toll fee, ambient temperature or road gradient.

In addition to the main driving route, when the route guidance information includes the route information of the at least one additional recommended route, the expected SOC reduction of the battery SOC for each additional recommended route may be determined by the control module 220, the remote server 400 or the mobile device 500. The control module 220 may determine the expected battery SOC for each additional recommended route based on the expected SOC reduction for each additional recommended route.

When the route guidance information includes two or more recommended routes, the control module 220 may select any one of the two or more additional recommended routes based on a result of comparing the expected battery SOC of each additional recommended route with the first reference SOC (or the target SOC), and change the main driving route to the selected recommended route. When the expected battery SOCs for the two or more additional recommended routes are less than or more than the first reference SOC (or the target SOC), the control module 220 may select the recommended route related to any one expected battery SOC having the smallest difference from the first reference SOC (or the target SOC).

When only the expected battery SOC related to any one of the two or more additional recommended routes is less than the first reference SOC (or the target SOC), the control module 220 may select the additional recommended route.

Alternatively, the two or more additional recommended routes may be provided to the passenger of the electric vehicle EV by the navigation device or the mobile device 500, and a user input to select any one of the two or more additional recommended routes may be received by the navigation device or mobile device 500. The control module 220 may change the main driving route to the user's selected one of the two or more additional recommended routes based on the user input.

For example, assume that the first reference SOC is 90%, the expected battery SOC of the main driving route (i.e., the first expected battery SOC) is 93%, the expected battery SOC of the first additional recommended route is 91%, the expected battery SOC of the second additional recommended route is 89%, and the expected battery SOC of the third additional recommended route is 84%. In this case, because the expected battery SOC of the main driving route exceeds the first reference SOC, when driving along the main driving route continues, entry may be denied upon arrival at the facility. Accordingly, the main driving route may be replaced with the second or third additional recommended route having the expected battery SOC that is equal to or less than the first reference SOC (or the target SOC). Preferably, the second additional recommended route related to the expected battery SOC having the smaller SOC difference from the first reference SOC (or the target SOC) may be selected.

The first pre-discharging operation may include a function of forcibly activating at least one electrical equipment of the peripheral device 50 of the electric vehicle EV. The forced activation of the electrical equipment may include a function of switching the electrical equipment from a sleep mode to a wake-up mode or increasing the operation intensity in the wake-up mode without the passenger's manipulation. Because each electrical equipment is installed to work using the energy from the battery B, the discharge acceleration function may trigger a rapid reduce of the battery SOC when it is performed. TABLE 1 below summarizes the types of electrical equipment and examples of their activation operations.

TABLE 1

| Electrical equipment | Discharge acceleration function |
|---|---|
| Passenger-compartment heating system | Start the seat heating, level up the seat heating |
| Passenger-compartment air conditioning system | Activate the air conditioner, increase the wind volume, and increase the air circulation speed. |

(continued)

| Electrical equipment | Discharge acceleration function |
|---|---|
| Battery cooling system | lower the coolant temperature and increase the output of the battery cooling pump. |
| Entertainment system | Increase the display brightness, increase the speaker volume, change the radio frequency |
| Lighting system | Increase the passenger-compartment light intensity |
| Air pressure control system | lower the tire pressure |
| Communication system | Enable Wi-Fi hotspot/tethering/Bluetooth connection of the passenger's mobile device |

The first pre-discharging operation may include a vehicle-to-vehicle (V2V) charging function. The V2V charging operation may be an operation of searching for nearby other electric vehicle that needs charging, moving to the location of the found electric vehicle, and charging the battery of the other electric vehicle with the battery B of the electric vehicle EV. The control module 220 may receive vehicle identification information of the other electric vehicle and request the navigation device or the mobile device 500 to set the location of the other electric vehicle as a stopover site, using the information input/output module 210. The history of the V2V charging function of the electric vehicle EV (for example, date, number of times, accumulated energy amount) may be recorded in the vehicle entry management apparatus 200, the remote server 400 and/or the mobile device 500. A reward corresponding to the history of the V2V charging function of the electric vehicle EV may be automatically calculated. The automatically calculated reward may be used when the electric vehicle EV is supplied with a charging service through the V2V charging function afterwards.

The first pre-discharging operation may include reducing the amount of regenerative power of the electric vehicle EV. For example, the power converter 30 may reduce the amount of regenerative power by stopping an operation of generating the charge power using the regenerative power from the motor 40 in response to a braking event of the electric vehicle EV.

The first pre-discharging operation may include a change in driving mode of the electric vehicle EV (for example, an eco-to-normal mode change, a normal-to-sport mode change).

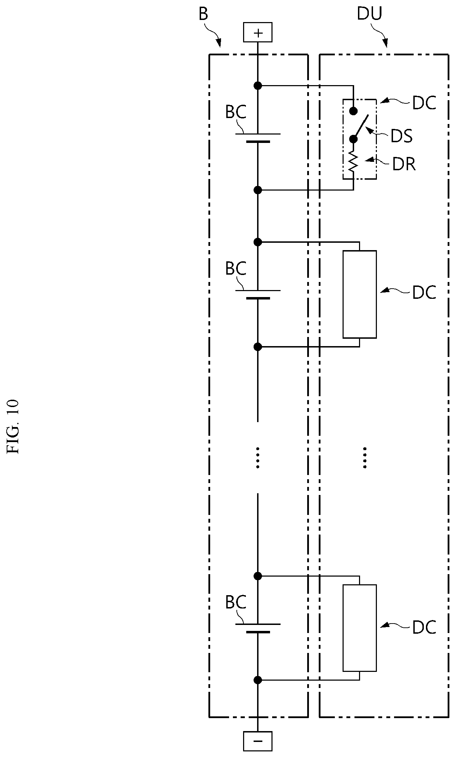

The first pre-discharging operation may include a function for activating cell balancing for the battery B. The cell balancing will be described with reference to FIG. 10 below.

When the first pre-discharging operation is performed, the battery B may drain fast while driving to the facility. Accordingly, it may be possible to significantly reduce the likelihood that the electric vehicle EV will arrive at the facility at higher battery SOC than the first reference SOC (or the target SOC).

FIG. 10 is a diagram referenced in describing cell balancing.

Referring to FIG. 10, the battery B including a series circuit of the plurality of battery cells BC is shown. The cell balancing may be performed by a battery discharge unit DU of the battery management system 100.

The cell balancing is usually used to reduce a voltage difference between the plurality of battery cells BC, and the present disclosure may use it to forcibly reduce the SOC of the battery B.

While the electric vehicle EV is driving toward the facility, when the first expected battery SOC exceeds the first reference SOC, the control module 220 may transmit a balancing request to the battery management system 100. In response to the balancing request, the battery management system 100 may activate the battery discharge unit DU at least temporarily.

When the first expected battery SOC is reduced below the first reference SOC (or the target SOC) before the electric vehicle EV arrives at the facility, the control module 220 may transmit a balancing stop request to the battery management system 100. The battery management system 100 may deactivate the battery discharge unit DU in response to the balancing stop request.

The battery discharge unit DU may include a plurality of discharge circuits DC. The plurality of discharge circuits DC may be connected in parallel to the plurality of battery cells BC, respectively.

The discharge circuit DC may include a series circuit of a switch DS and a resistor DR. When the switch DS of the discharge circuit DC is turned on, the energy of the battery cell BC is consumed by the resistor DR.

The activation of the battery discharge unit DU may refer to controlling at least one switch DS of the plurality of discharge circuits DC into a turn-on state.

The deactivation of the battery discharge unit DU may refer to controlling the switches DS of all of the plurality of discharge circuits DC into a turn-off state.

Although FIG. 10 shows each battery cell BC connected in parallel to the discharge circuit DC, this is for the purpose of illustration only. That is, one discharge circuit DC may be connected in parallel to each set of two or more battery cells BC connected either in series or in parallel, or both.

The control module 220 may determine the discharge intensity for at least one of the plurality of discharge circuits DC based on the SOC difference between the first expected battery SOC and the first reference SOC and the remaining time until arrival at the facility. The correspondence relationship between the SOC difference, the remaining time and the discharge intensity may be pre-stored in the control module 220 and/or the battery management system 100 in the form of a data table or a function. An example of the discharge intensity may include a switching duty cycle. For example, as the SOC difference increases and/or as the remaining time decreases, the switching duty cycle as the discharge intensity may increase.

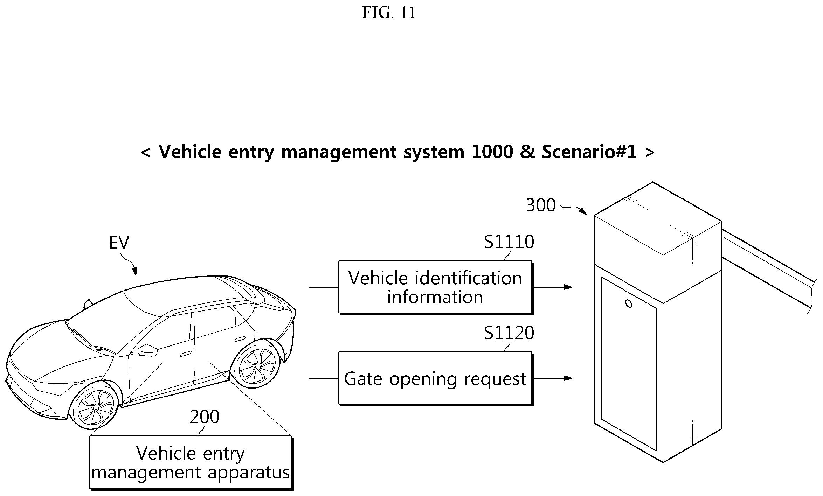

Hereinafter, the operation of allowing the entry according to the step S830 of FIG. 8 will be described in more detail with reference to FIGS. 11 to 22.

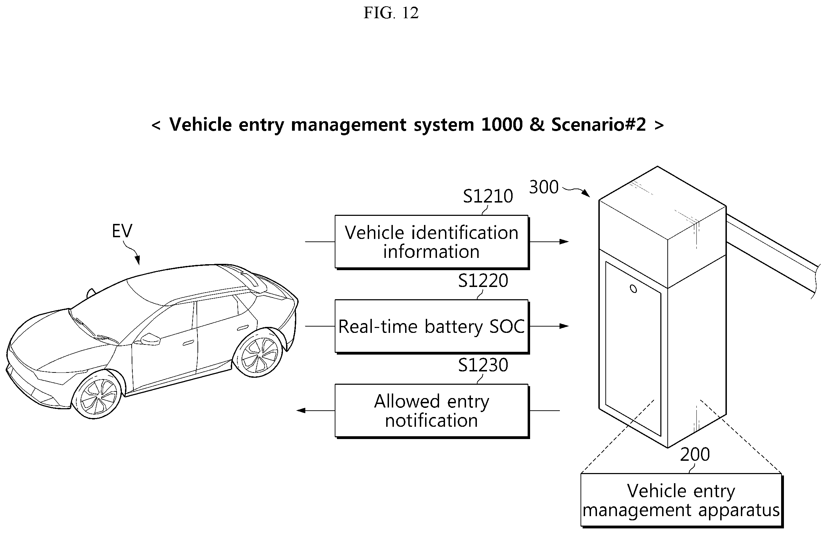

FIG. 11 and FIG. 12 are diagrams referenced in describing exemplary information transmission and reception situations between the electric vehicle and the vehicle access controller in the vehicle entry management system according to FIG. 4.

FIG. 11 relates to scenario #1 where the vehicle entry management apparatus 200 is included in the electric vehicle EV of the vehicle entry management system 1000. Referring to FIG. 11, the vehicle access controller 300 may wait for the vehicle identification information of the electric vehicle EV after it has acquired the vehicle image and/or the code image of the electric vehicle EV.

The information input/output module 210 may transmit the vehicle identification information of the electric vehicle EV to the vehicle access controller 300 (S1110). The vehicle access controller 300 may determine whether the vehicle identification information based on the vehicle image and/or the code image matches the vehicle identification information received from the information input/output module 210.

The information input/output module 210 may transmit the gate opening request to the vehicle access controller 300 (S1120). When it is determined that the two vehicle identification information match, the vehicle access controller 300 may control the barrier gate 330 into the open state in response to the gate opening request.

FIG. 12 relates to scenario #2 where the vehicle entry management apparatus 200 is included in the vehicle access controller 300 of the vehicle entry management system 1000. Referring to FIG. 12, the vehicle access controller 300 may wait for the vehicle identification information of the electric vehicle EV after it has acquired the vehicle image and/or the code image of the electric vehicle EV. The information input/output module 210 may transmit the vehicle identification information and the real-time battery SOC of the electric vehicle EV to the vehicle access controller 300 (S1210, S1220). The vehicle access controller 300 may determine whether the vehicle identification information based on the vehicle image and/or the code image matches the vehicle identification information received from the information input/output module 210.

When it is determined that the two vehicle identification information match, the information input/output module 210 of the vehicle access controller 300 may transmit the allowed entry notification to the electric vehicle EV in response to the command from the control module 220 (S1230), and the control module 220 may control the barrier gate 330 into the open state.

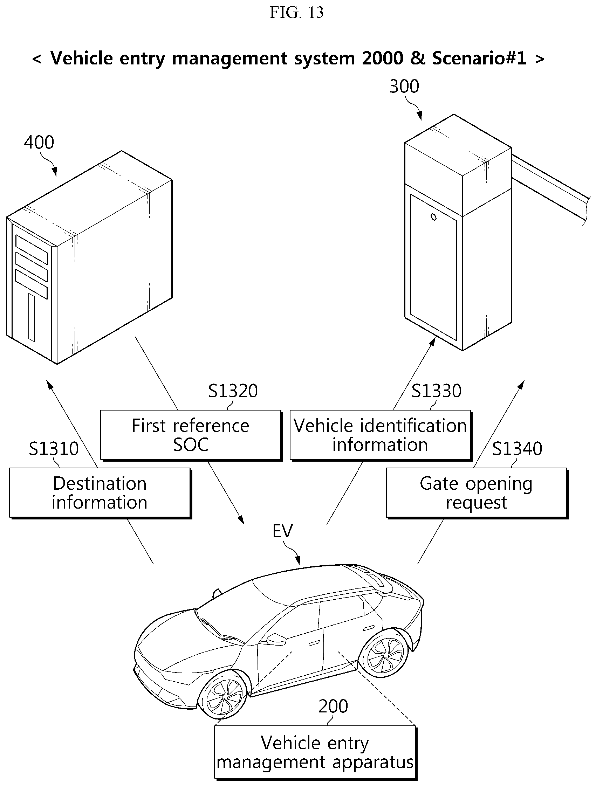

FIGS. 13 to 15 are diagrams referenced in describing exemplary information transmission and reception situations between the electric vehicle, the vehicle access controller and the remote server of the vehicle entry management system according to FIG. 5.

FIG. 13 relates to scenario #1 where the vehicle entry management apparatus 200 is included in the electric vehicle EV of the vehicle entry management system 2000. Referring to FIG. 13, the vehicle access controller 300 may wait for the vehicle identification information of the electric vehicle EV.

The information input/output module 210 may transmit the destination information to the remote server 400 (S1310) and receive the first reference SOC corresponding to the destination information from the remote server 400 (S1320). The control module 220 may compare the first reference SOC with the real-time battery SOC.

The information input/output module 210 may transmit the vehicle identification information of the electric vehicle EV to the vehicle access controller 300 (S1330). The vehicle access controller 300 may determine whether the vehicle identification information based on the vehicle image and/or the code image matches the vehicle identification information received from the information input/output module 210.

The information input/output module 210 may transmit the gate opening request to the vehicle access controller 300 when the real-time battery SOC is equal to or less than the first reference SOC (S1340). When it is determined that the two vehicle identification information match, the vehicle access controller 300 may control the barrier gate 330 into the open state in response to the gate opening request.

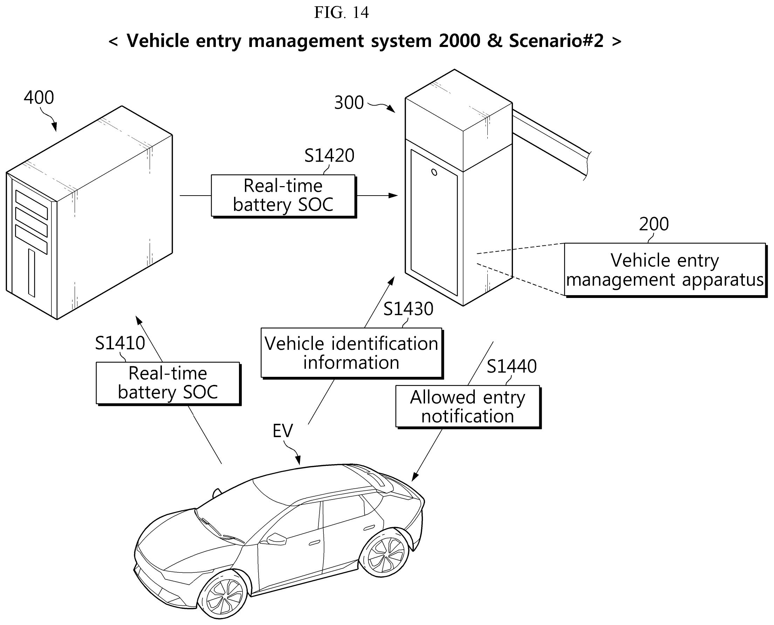

FIG. 14 relates to scenario #2 where the vehicle entry management apparatus 200 is included in the vehicle access controller 300 of the vehicle entry management system 2000. Referring to FIG. 14, the electric vehicle EV may transmit the information indicating the real-time battery SOC to the remote server 400 (S1410). The remote server 400 may transmit the information indicating the real-time battery SOC to the vehicle access controller 300 (S1420).

The vehicle access controller 300 may wait for the vehicle identification information of the electric vehicle EV. The electric vehicle EV may transmit the vehicle identification information of the electric vehicle EV to the vehicle access controller 300 (S1430). The vehicle access controller 300 may determine whether the vehicle identification information based on the vehicle image and/or the code image matches the vehicle identification information received from the information input/output module 210. When it is determined that the two vehicle identification information match, the information input/output module 210 of the vehicle access controller 300 may transmit the allowed entry notification to the electric vehicle EV in response to the command from the control module 220 (S1440), and the control module 220 may control the barrier gate 330 into the open state.

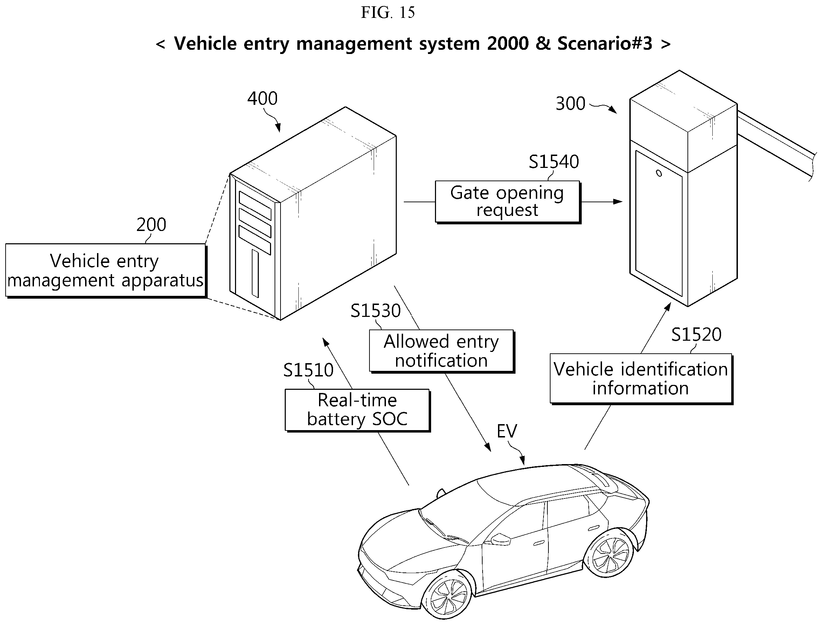

FIG. 15 relates to scenario #3 where the vehicle entry management apparatus 200 is included in the remote server 400 of the vehicle entry management system 2000. Referring to FIG. 15, the information input/output module 210 of the remote server 400 may collect the information indicating the real-time battery SOC from the electric vehicle EV (S1510). The vehicle access controller 300 may wait for the vehicle identification information of the electric vehicle EV. The electric vehicle EV may transmit the vehicle identification information of the electric vehicle EV to the vehicle access controller 300 (S1520).

When the real-time battery SOC is equal to or less than the first reference SOC, the control module 220 of the remote server 400 may control the information input/output module 210 to transmit the allowed entry notification to the electric vehicle EV and the gate opening request to the vehicle access controller 300 (S1530, S1540).

The vehicle access controller 300 may determine whether the vehicle identification information based on the vehicle image and/or the code image matches the vehicle identification information received from the information input/output module 210.

When it is confirmed that the two vehicle identification information match, the vehicle access controller 300 may control the barrier gate 330 into the open state in response to the gate opening request.

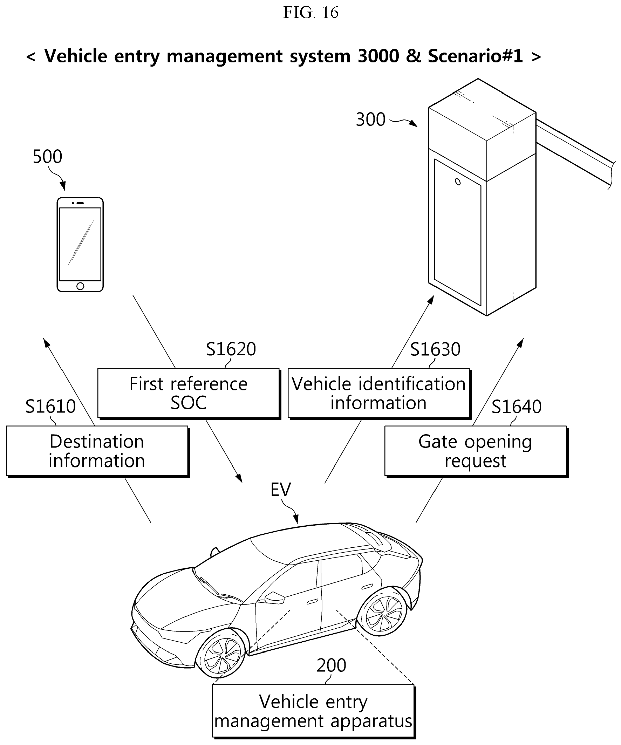

FIGS. 16 to 18 are diagrams referenced in describing exemplary information transmission and reception situations between the electric vehicle, the vehicle access controller and the mobile device in the vehicle entry management system according to FIG. 6.

FIG. 16 relates to scenario #1 where the vehicle entry management apparatus 200 is included in the electric vehicle EV of the vehicle entry management system 3000. Referring to FIG. 16, the vehicle access controller 300 may wait for the vehicle identification information of the electric vehicle EV.

The information input/output module 210 may transmit the destination information (for example, the facility's address) to the mobile device 500 (S1610) and receive the first reference SOC corresponding to the destination information from the mobile device 500 (S1620). The control module 220 may compare the first reference SOC with the real-time battery SOC.

The information input/output module 210 may transmit the vehicle identification information of the electric vehicle EV to the vehicle access controller 300 (S1630). The vehicle access controller 300 may determine whether the vehicle identification information based on the vehicle image and/or the code image matches the vehicle identification information received from the information input/output module 210.

When the real-time battery SOC is equal to or less than the first reference SOC, the information input/output module 210 may transmit the gate opening request to the vehicle access controller 300 (S1640). When it is determined that the two vehicle identification information match, the vehicle access controller 300 may control the barrier gate 330 into the open state in response to the gate opening request.

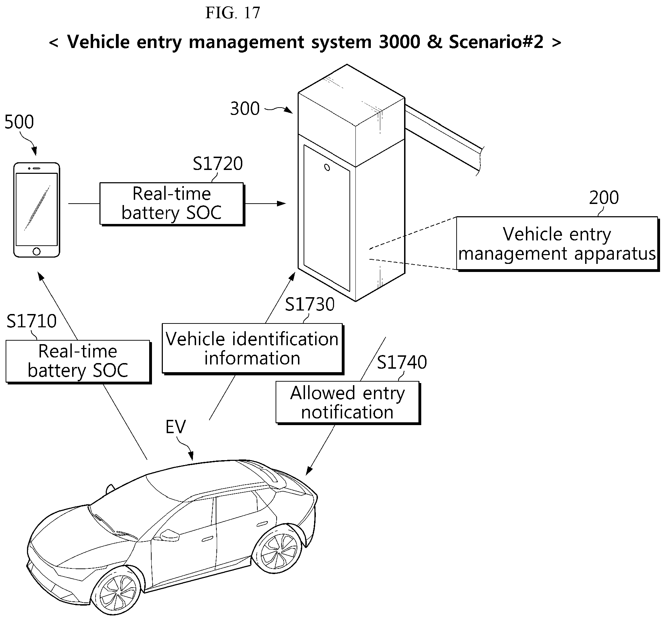

FIG. 17 relates to scenario #2 where the vehicle entry management apparatus 200 is included in the vehicle access controller 300 of the vehicle entry management system 3000. Referring to FIG. 17, the information input/output module 210 may transmit the information indicating the real-time battery SOC to the mobile device 500 (S1710). The mobile device 500 may transmit the information indicating the real-time battery SOC to the vehicle access controller 300 (S1720).

The vehicle access controller 300 may wait for the vehicle identification information of the electric vehicle EV. The electric vehicle EV may transmit the vehicle identification information of the electric vehicle EV to the vehicle access controller 300 (S1730). The vehicle access controller 300 may determine whether the vehicle identification information based on the vehicle image and/or the code image matches the vehicle identification information received from the information input/output module 210. When it is determined that the two vehicle identification information match, the information input/output module 210 of the vehicle access controller 300 may transmit the allowed entry notification to the electric vehicle EV in response to the command from the control module 220 (S1740), and the control module 220 may control the barrier gate 330 into the open state.

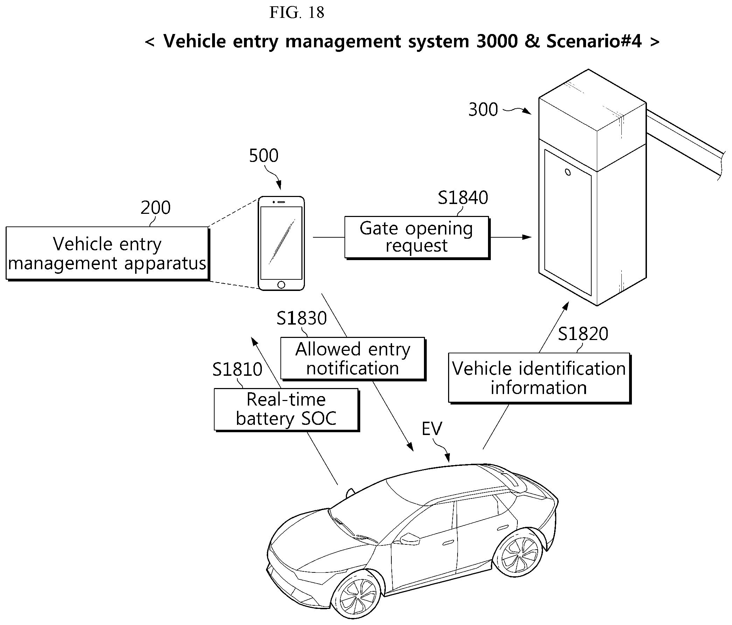

FIG. 18 relates to scenario #4 where the vehicle entry management apparatus 200 is included in the mobile device 500 of the vehicle entry management system 3000. Referring to FIG. 18, the information input/output module 210 of the mobile device 500 may collect the information indicating the real-time battery SOC from the electric vehicle EV (S1810). The vehicle access controller 300 may wait for the vehicle identification information of the electric vehicle EV. The electric vehicle EV may transmit the vehicle identification information of the electric vehicle EV to the vehicle access controller 300 (S1820).

When the real-time battery SOC is equal to or less than the first reference SOC, the control module 220 of the mobile device 500 may control the information input/output module 210 to transmit the allowed entry notification to the electric vehicle EV and the gate opening request to the vehicle access controller 300 (S1830, S1840).

The vehicle access controller 300 may determine whether the vehicle identification information based on the vehicle image and/or the code image matches the vehicle identification information received from the information input/output module 210.

When the information input/output module 210 of the mobile device 500 determines that the two vehicle identification information match in response to the command of the control module 220, the vehicle access controller 300 may control the barrier gate 330 into the open state in response to the gate opening request.

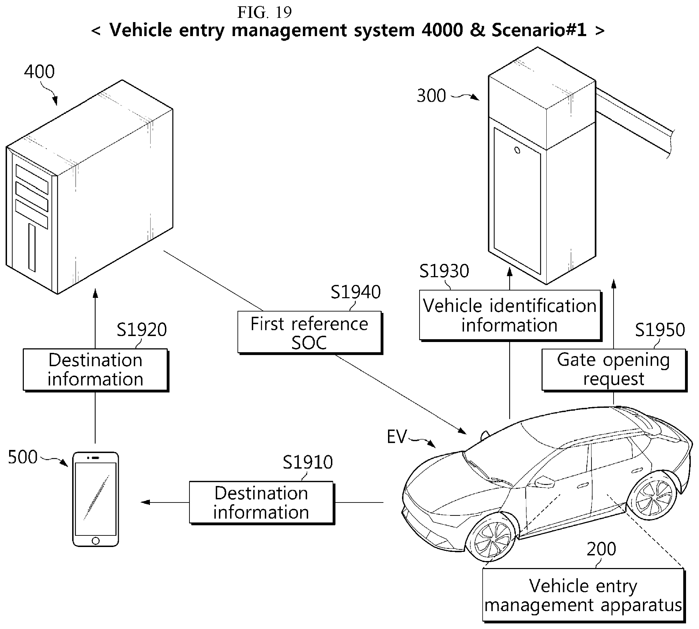

FIGS. 19 to 22 are diagrams referenced in describing exemplary information transmission and reception situations between the electric vehicle, the vehicle access controller, the remote server and the mobile device in the vehicle entry management system according to FIG. 7.

FIG. 19 relates to scenario #1 where the vehicle entry management apparatus 200 is included in the electric vehicle EV of the vehicle entry management system 4000. Referring to FIG. 19, the vehicle access controller 300 may wait for the vehicle identification information of the electric vehicle EV.

The information input/output module 210 may transmit the destination information to the mobile device 500 (S1910). The mobile device 500 may transmit the destination information to the remote server 400 (S1920).

The information input/output module 210 may transmit the vehicle identification information of the electric vehicle EV to the vehicle access controller 300 (S1930). The vehicle access controller 300 may determine whether the vehicle identification information based on the vehicle image and/or the code image matches the vehicle identification information received from the information input/output module 210.

The information input/output module 210 may receive the first reference SOC corresponding to the destination information from the remote server 400 (S1940). The control module 220 may compare the first reference SOC with the real-time battery SOC.

When the real-time battery SOC is equal to or less than the first reference SOC, the information input/output module 210 may transmit the gate opening request to the vehicle access controller 300 (S1950). When it is determined that the two vehicle identification information match, the vehicle access controller 300 may control the barrier gate 330 into the open state in response to the gate opening request.

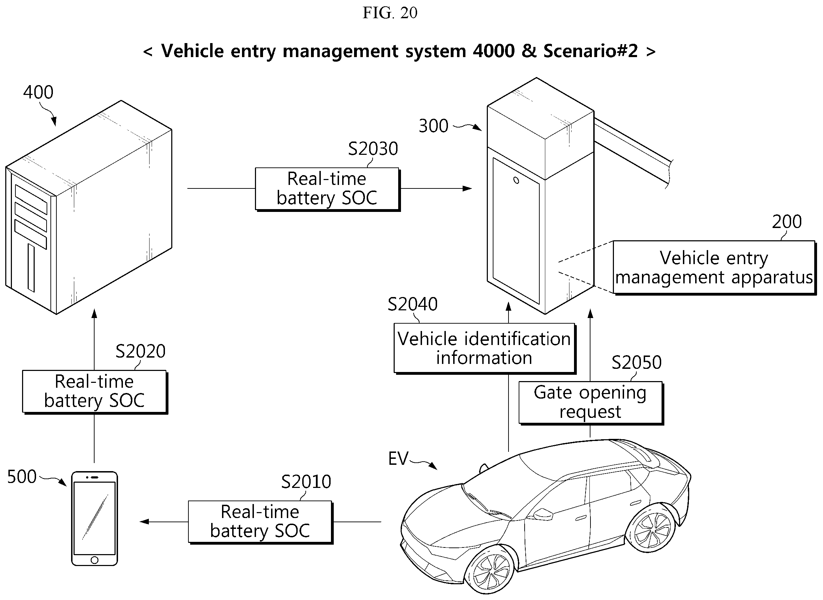

FIG. 20 relates to scenario #2 where the vehicle entry management apparatus 200 is included in the vehicle access controller 300 of the vehicle entry management system 4000. Referring to FIG. 20, the electric vehicle EV may transmit the information indicating the real-time battery SOC to the mobile device 500 (S2010). The real-time battery SOC may be transmitted to the vehicle access controller 300 via the mobile device 500 and the remote server 400 (S2020, S2030).

The vehicle access controller 300 may wait for the vehicle identification information of the electric vehicle EV. The information input/output module 210 of the vehicle access controller 300 may receive the vehicle identification information from the electric vehicle EV (S2040). The vehicle access controller 300 may determine whether the vehicle identification information based on the vehicle image and/or the code image matches the vehicle identification information received from the information input/output module 210. When it is determined that the two vehicle identification information match, the information input/output module 210 of the vehicle access controller 300 may transmit the allowed entry notification to the electric vehicle EV in response to the command from the control module 220 (S2050), and the control module 220 may control the barrier gate 330 into the open state.

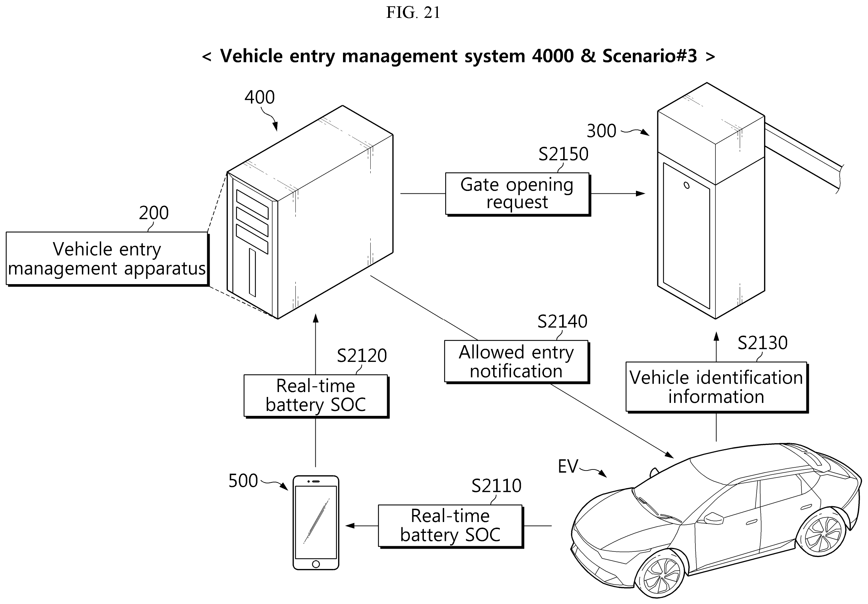

FIG. 21 relates to scenario #3 where the vehicle entry management apparatus 200 is included in the remote server 400 of the vehicle entry management system 4000. Referring to FIG. 21, the electric vehicle EV may transmit the information indicating the real-time battery SOC to the mobile device 500 (S2110), and the information input/output module 210 of the remote server 400 may collect the information indicating the real-time battery SOC from the mobile device 500 (S2120).

The vehicle access controller 300 may wait for the vehicle identification information of the electric vehicle EV. The electric vehicle EV may transmit the vehicle identification information of the electric vehicle EV to the vehicle access controller 300 (S2130).

When the real-time battery SOC is equal to or less than the first reference SOC, the control module 220 of the remote server 400 may control the information input/output module 210 to transmit the allowed entry notification to the electric vehicle EV and the gate opening request to the vehicle access controller 300 (S2140, S2150).

The vehicle access controller 300 may determine whether the vehicle identification information based on the vehicle image and/or the code image matches the vehicle identification information received from the information input/output module 210.

When it is determined that the two vehicle identification information match, the vehicle access controller 300 may control the barrier gate 330 into the open state in response to the gate opening request.

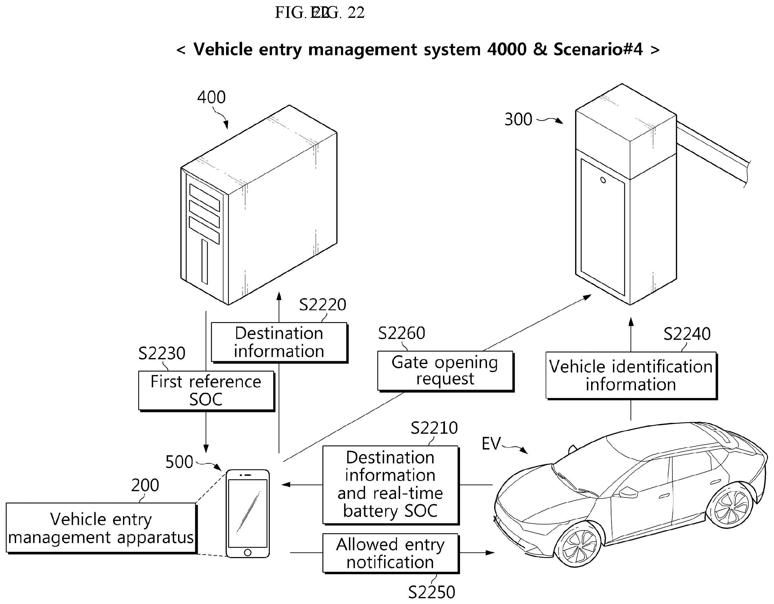

FIG. 22 relates to scenario #4 where the vehicle entry management apparatus 200 is included in the mobile device 500 of the vehicle entry management system 4000. Referring to FIG. 22, the information input/output module 210 of the mobile device 500 may collect the information indicating the real-time battery SOC together with the destination information from the electric vehicle EV (S2210). The information input/output module 210 may transmit the destination information to the remote server 400 and query the first reference SOC corresponding to the destination information from the remote server 400 (S2220, S2230).

The vehicle access controller 300 may wait for the vehicle identification information of the electric vehicle EV. The electric vehicle EV may transmit the vehicle identification information of the electric vehicle EV to the vehicle access controller 300 (S2240).

When the real-time battery SOC is equal to or less than the first reference SOC, the control module 220 of the mobile device 500 may control the information input/output module 210 to transmit the allowed entry notification to the electric vehicle EV and the gate opening request to the vehicle access controller 300 (S2250, S2260).

The vehicle access controller 300 may determine whether the vehicle identification information based on the vehicle image and/or the code image matches the vehicle identification information received from the information input/output module 210.

When it is determined that the two vehicle identification information match, the vehicle access controller 300 may control the barrier gate 330 into the open state in response to the gate opening request.

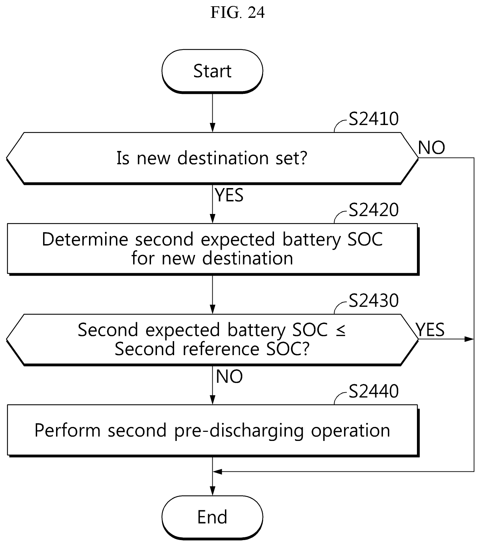

FIG. 23 is a diagram referenced in describing a situation in which the electric vehicle entered the facility, and FIG. 24 is a flowchart schematically showing the vehicle entry management method according to another embodiment of the present disclosure. The description made with reference to FIGS. 23 and 24 below may be applied to at least one of the vehicle entry management systems 1000, 2000, 3000, 4000 according to various embodiments described with reference to FIGS. 1 to 22.

FIG. 23 shows the electric vehicle EV entering the facility 2310 and connected to a charger CHR. The charger CHR may be present within the facility 2310. For example, as illustrated, the exterior of the charger CHR may take the form of a device that acts as a vehicle stopper. In addition to the stopper type, the exterior of the charger CHR may be provided in the form of a typical stand type.

The charger CHR includes a charging circuit. The charger CHR may further include a discharging circuit. The charger CHR may further include an energy storage system. The energy storage system is used to store energy from the battery B of the electric vehicle EV through the discharging circuit. Additionally, the energy stored in the energy storage system may be supplied to charge another electric vehicle by the charging circuit. The energy storage system may be installed at the underground, pillar and/or wall of the facility 2310.

When the electric vehicle EV and the charger CHR are connected to each other through a cable, the electric vehicle EV may be charged or discharged by the charger CHR by the user's manipulation.

The charger CHR may supply charging energy to the electric vehicle EV in response to a charging request from the user of the electric vehicle EV. In this case, the charger CHR may limit the maximum battery SOC of the electric vehicle EV to the first reference SOC.

The method according to FIG. 24 may be another example of a set of subroutines that may be included in the step S320 of FIG. 3. The method according to FIG. 24 may be performed on the condition that the electric vehicle EV is connected to the charger CHR as shown in FIG. 23.

Referring to FIG. 24, in step S2410, the control module 220 may determine whether a new destination is set for the electric vehicle EV.

The user of the electric vehicle EV may set the new destination 2320 as a new destination of the electric vehicle EV using the navigation device of the electric vehicle EV or the mobile device 500. The new destination 2320 may be a type of facility, like the facility 2310. A main driving route from the current location 2310 to the new destination 2320 may be acquired by the navigation device or the mobile device 500.

In scenario #1, the vehicle entry management apparatus 200 may acquire new destination information from the navigation device of the electric vehicle EV through the wired communication channel. In Scenario #2, the vehicle entry management apparatus 200 may receive new destination information from the electric vehicle EV through the wireless communication channel. In Scenario #3, the vehicle entry management apparatus 200 may receive new destination information from the electric vehicle EV or the remote server 400 through the wireless communication channel. In Scenario #4, the vehicle entry management apparatus 200 may receive new destination information from the electric vehicle EV or the mobile device 500 through the wireless communication channel.

When a value of the step S2410 is "YES", step S2420 may be performed. When the value of the step S2410 is "NO", the method according to FIG. 24 may end.

In the step S2420, the control module 220 determines a second expected battery SOC for the new destination 2320 based on the main driving route to the new destination 2320 and the real-time battery SOC. The second expected battery SOC may indicate an estimated battery SOC at the expected time of arrival of the electric vehicle EV to the new destination 2320. The second reference SOC may be preset as the criterion for entry permission into the new destination 2320 or may be pre-registered in the control module 220 by the user.

In step S2430, the control module 220 determines whether the second expected battery SOC is equal to or less than the second reference SOC. The criterion (i.e., the first reference SOC) of entry permission into the facility 2310 and the criterion (i.e., the second reference SOC) of entry permission into the new destination 2320 may be equal or different. When the criterion (for example, SOC 80%) of entry permission into the new destination 2320 is stricter than the criterion (for example, SOC 90%) of entry permission into the facility 2310, it may be necessary to perform a second pre-discharging operation using the charger CHR before leaving the facility 2310. When a value of the step S2430 is "YES", the method according to FIG. 24 may end. When the value of the step S2430 is "NO", step S2440 may be performed.

In the step S2440, the control module 220 performs the second pre-discharging operation (referred to as 'post-entry discharging operation') for the electric vehicle EV. The second pre-discharging operation may include at least one function for increasing the energy consumption of the battery B during the remaining time until arrival at the facility to make the second expected battery SOC equal to or less than the second reference SOC.

By the operation of any one of the vehicle entry management apparatus 200, the electric vehicle EV, the remote server 400 or the mobile device 500 or a combination thereof, a target SOC reduction may be determined. The target SOC reduction may be determined to be equal to or larger than the SOC difference between the second expected battery SOC and the second reference SOC.

For example, assume that the SOC difference between the real-time battery SOC and the second reference SOC is 10%, and the expected SOC reduction for the main driving route from the facility 2310 to the new destination 2320 is SOC 7%. The target SOC reduction may be determined to be equal to or more than SOC 3%. For reference, the main driving route from the facility 2310 to the new destination 2320 and its expected SOC reduction may be determined by the same method as the method for determining the main driving route to the facility 2310 and its expected SOC reduction.

The user may check the target SOC reduction through the electric vehicle EV or the mobile device 500, and manipulate the charger CHR to perform the second pre-discharging operation based on the target SOC reduction.

A discharging request indicating the target SOC reduction may be wirelessly transmitted from the information input/output module 210 to the charger CHR. In response to the received discharging request, the charger CHR may reduce the battery SOC of the electric vehicle EV by the target SOC reduction and stop discharging the electric vehicle EV.

The amount of energy supplied from the electric vehicle EV to the charger CHR by the second pre-discharging operation may be measured by the electric vehicle EV or the charger CHR, and the measured amount of energy may be recorded in the vehicle entry management apparatus 200, the electric vehicle EV, the vehicle access controller 300, the remote server 400 and/or the mobile device 500.

Each time the second pre-discharging operation is performed, the reward (for example, mileage accrual) corresponding to the amount of energy consumed by the electric vehicle EV by the second pre-discharging operation may be provided to the user of the electric vehicle EV. The user of the electric vehicle EV may receive benefits such as discounts on charging fees of the electric vehicle EV using the provided reward. For example, assume that the electric vehicle EV received a charging service using the charger at the new destination 2320 after it has entered the new destination 2320. The user of the electric vehicle EV may pay at least a part of the service fee for the charging service at the new destination 2320 using the accumulated mileage.

The embodiments of the present disclosure described hereinabove are not realized only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspects of the present disclosure and the appended claims and their equivalents.

Additionally, as many substitutions, modifications and changes may be made to the present disclosure as described above by those skilled in the art without departing from the technical aspects of the present disclosure, the present disclosure is not limited by the above-described embodiments and the accompanying drawings, and some or all of the embodiments may be selectively combined to allow various modifications.

Another embodiment of the present disclosure may provide a computer-readable recording medium having recorded thereon a program for causing a computer to perform the above-described embodiments.

The program may be implemented by hardware components, software components and/or a combination thereof. The program may be executed by all systems capable of executing computer-readable instructions.

The software may include computer programs, code, instructions or a combination thereof, and may configure a processing device to operate as desired or command the processing device independently or collectively.

The software may be a computer program including instructions stored on computer-readable storage media. The computer-readable storage media include, for example, magnetic recording media (for example, read-only memory (ROM), random-access memory (RAM), floppy disk, hard disk) and optical reader media (for example, CD-ROM, Digital Versatile Disc (DVD)). The computer-readable storage medium may be distributed across computer systems connected via a network to store and execute the computer-readable code in a distributed manner. The recording medium may be read by the computer, stored in the memory and executed by the processor.

The computer-readable storage medium may be provided in the form of a non-transitory storage medium. Here, the 'non-transitory storage medium' refers to a tangible device and does not include a signal (for example, electromagnetic waves), and this term encompasses semi-permanent data storage on the recording medium and temporary data storage. For example, the 'non-transitory storage medium' may include a buffer and/or server in which data is temporarily stored.

Additionally, the program may be provided in such a manner that it is included in a computer program product. The computer program product may be a product that is transacted between a seller and a buyer.

The computer program product may include a software program and a computer-readable recording medium on which the software program is stored. For example, the computer program product may include a product (for example, a downloadable application) in the form of a software program distributed electronically through an electronic device manufacturer or an electronic market. For electronic distribution, at least a part of the software program may be stored on the recording medium or temporarily created. In this case, the recording medium may be a recording medium of the electronic device manufacturer's server, the electronic market's server or the intermediary server that temporarily stores the software program.

## Claims

1. A vehicle entry management method comprising:

   acquiring vehicle location information and vehicle battery information of an electric vehicle; and
   performing a vehicle entry management operation related to entry of the electric vehicle into a facility based on the vehicle location information and the vehicle battery information.

2. The vehicle entry management method according to claim 1,
   wherein performing the vehicle entry management operation includes:

   determining whether a real-time battery state of charge (SOC) based on the vehicle battery information is equal to or less than a first reference SOC when it is determined, based on the vehicle location information, that the electric vehicle has arrived at the facility; and
   performing an operation of disallowing the entry of the electric vehicle, when the real-time battery SOC is determined to be higher than the first reference SOC.

3. The vehicle entry management method according to claim 2,
   wherein the operation of disallowing the entry includes:
   at least one of a function of transmitting a disallowed entry notification to the electric vehicle or a function of controlling a barrier gate installed at an entrance of the facility into a closed state.

4. The vehicle entry management method according to claim 1,
   wherein performing the vehicle entry management operation includes:

   determining whether a real-time battery SOC based on the vehicle battery information is equal to or less than a first reference SOC when it is determined, based on the vehicle location information, that the electric vehicle has arrived at the facility; and
   performing an operation of allowing the entry of the electric vehicle, when the real-time battery SOC is determined to be equal to or less than the first reference SOC.

5. The vehicle entry management method according to claim 4,
   wherein the operation of allowing the entry includes:
   at least one of a function of transmitting an allowed entry notification to the electric vehicle or a function of controlling a barrier gate installed at an entrance of the facility into an open state.

6. The vehicle entry management method according to claim 1,
   wherein performing the vehicle entry management operation includes:

   determining a first expected battery SOC at an expected time of arrival at the facility based on the vehicle location information and the vehicle battery information when it is determined, based on the vehicle location information, that the electric vehicle has not yet arrived at the facility; and
performing a first pre-discharging operation for the electric vehicle, when the first expected battery SOC is higher than the first reference SOC.

7. The vehicle entry management method according to claim 6,
wherein the first pre-discharging operation includes:
at least one of a function of changing a driving route of the electric vehicle, a function of changing a driving mode of the electric vehicle, a function of forcibly activating at least one electrical equipment of the electric vehicle, a function of activating cell balancing for a battery of the electric vehicle, or a function of supplying charge power to another electric vehicle.

8. The vehicle entry management method according to claim 1, comprising:

determining, after the electric vehicle has entered the facility, a second expected battery SOC at an expected time of arrival of the electric vehicle at a new destination; and
performing a second pre-discharging operation using a charger installed at the facility when the second expected battery SOC is higher than a second reference SOC.

9. A vehicle entry management apparatus comprising:

an information input/output module configured to acquire vehicle location information and vehicle battery information of an electric vehicle; and
a control module configured to perform a vehicle entry management operation related to entry of the electric vehicle into a facility based on the vehicle location information and the vehicle battery information.

10. The vehicle entry management apparatus according to claim 9,
wherein the control module is configured to:

determine whether a real-time battery state of charge (SOC) based on the vehicle battery information is equal to or less than a first reference SOC when it is determined, based on the vehicle location information, that the electric vehicle has arrived at the facility, and
perform an operation of disallowing the entry of the electric vehicle when the real-time battery SOC is determined to be higher than the first reference SOC.

11. The vehicle entry management apparatus according to claim 10,
wherein the operation of disallowing the entry includes:
at least one of a function of transmitting a disallowed entry notification to the electric vehicle or a function of controlling a barrier gate installed at an entrance of the facility into a closed state.

12. The vehicle entry management apparatus according to claim 9,
wherein the control module is configured to:

determine whether a real-time battery SOC based on the vehicle battery information is equal to or less than a first reference SOC when it is determined, based on the vehicle location information, that the electric vehicle has arrived at the facility, and
perform an operation of allowing the entry of the electric vehicle into the facility when the real-time battery SOC is determined to be equal to or less than the first reference SOC.

13. The vehicle entry management apparatus according to claim 9,
wherein the control module is configured to:

determine a first expected battery SOC at an expected time of arrival at the facility based on the vehicle location information and the vehicle battery information when it is determined, based on the vehicle location information, that the electric vehicle has not yet arrived at the facility, and
perform a first pre-discharging operation for the electric vehicle when the first expected battery SOC is determined to be higher than the first reference SOC.

14. The vehicle entry management apparatus according to claim 13,

wherein the first pre-discharging operation includes:
at least one of a function of changing a driving route of the electric vehicle, a function of changing a driving mode of the electric vehicle, a function of forcibly activating at least one electrical equipment of the electric vehicle, a function of activating cell balancing for a battery of the electric vehicle, or a function of supplying charge power to another electric vehicle.

15. The vehicle entry management apparatus according to claim 9,
wherein the control module is configured to:

determine, after the electric vehicle entered the facility, a second expected battery SOC at an expected time of arrival of the electric vehicle at a new destination, and
perform a second pre-discharging operation using a charger installed at the facility when the second expected battery SOC is higher than a second reference SOC.

FIG. 1

FIG. 2

200

Vehicle entry management apparatus

210

Information input/output module

220

Control module

FIG. 3

```
        ┌─────────────┐
        │    Start     │
        └──────┬──────┘
               │
               ▼                           ⌐S310
┌──────────────────────────────────────────┐
│    Acquire vehicle location information     │
│      and vehicle battery information        │
└──────────────────────┬─────────────────────┘
                       │
                       ▼                   ⌐S320
┌──────────────────────────────────────────┐
│   Perform vehicle entry management operation │
└──────────────────────┬─────────────────────┘
                       │
                       ▼
              ┌─────────────┐
              │     End      │
              └─────────────┘
```

FIG. 4

< **Vehicle entry management system 1000** >

FIG. 5

< Vehicle entry management system 2000 >

300

400

Communication
channel

EV

FIG. 6

< Vehicle entry management system 3000 >

FIG. 7

< Vehicle entry management system 4000 >

FIG. 8

```
                    ┌──────────────┐
                    │    Start     │
                    └──────┬───────┘
                           │        ╭─S810
              ┌────────────▼────────────┐
              │  Did electric vehicle arrive  │ NO
          ────┤       at facility?      ├────► S910
              └────────────┬────────────┘
                        YES │      ╭─S820
              ┌────────────▼────────────┐
              │  Real-time battery SOC ≤ │ NO
              │    First reference SOC?  ├──────────────┐
              └────────────┬────────────┘              │
                        YES │     ╭─S830          ╭─S840│
        ┌──────────────────▼──────┐    ┌──────────▼──────────────┐
        │ Perform operation of allowing │    │ Perform operation of disallowing │
        │   entry of electric vehicle   │    │   entry of electric vehicle      │
        └──────────────┬──────────┘    └──────────┬──────────────┘
                       │◄─────────────────────────┘
              ┌────────▼───────┐
              │      End       │
              └────────────────┘
```

FIG. 9

FIG. 10

FIG. 11

< Vehicle entry management system 1000 & Scenario#1 >

EV

S1110

| Vehicle identification information |

S1120

| Gate opening request |

200

| Vehicle entry management apparatus |

300

EP 4 769 290 A1

FIG. 12

< **Vehicle entry management system 1000 & Scenario#2** >

EV

S1210 300

Vehicle identification information

S1220

Real-time battery SOC

S1230

Allowed entry notification

200

Vehicle entry management apparatus

EP 4 769 290 A1

FIG. 13

< Vehicle entry management system 2000 & Scenario#1 >

300

400

| S1320 | S1330 |
|---|---|
| First reference SOC | Vehicle identification information |

S1310

S1340

| Destination information | Gate opening request |
|---|---|

EV

200

Vehicle entry management apparatus

FIG. 14

< **Vehicle entry management system 2000 & Scenario#2** >

400

300

200
Vehicle entry
management apparatus

S1420
Real-time
battery SOC

S1430
Vehicle identification
information

S1410
Real-time
battery SOC

S1440
Allowed entry
notification

EV

EP 4 769 290 A1

FIG. 15

< Vehicle entry management system 2000 & Scenario#3 >

FIG. 16

< **Vehicle entry management system 3000 & Scenario#1** >

FIG. 17

< Vehicle entry management system 3000 & Scenario#2 >

EP 4 769 290 A1

FIG. 18

< Vehicle entry management system 3000 & Scenario#4 >

300

500

200
Vehicle entry
management apparatus

S1840
Gate opening
request

S1830
Allowed entry
notification

S1820
Vehicle identification
information

S1810
Real-time
battery SOC

EV

EP 4 769 290 A1

FIG. 19

< Vehicle entry management system 4000 & Scenario#1 >

FIG. 20

< Vehicle entry management system 4000 & Scenario#2 >

S2030
Real-time battery SOC

400

300

200
Vehicle entry management apparatus

S2040
Vehicle identification information

S2020
Real-time battery SOC

S2050
Gate opening request

500

S2010
Real-time battery SOC

EV

EP 4 769 290 A1

FIG. 21

< Vehicle entry management system 4000 & Scenario#3 >

EP 4 769 290 A1

< Vehicle entry management system 4000 & Scenario#4 >

EP 4 769 290 A1

FIG. 23

FIG. 24

```
                    ┌──────────┐
                    │  Start   │
                    └────┬─────┘
                         │
                         ▼                      S2410
        ╱───────────────────────────────────╲   NO
       ╱      Is new destination set?         ╲──────┐
        ╲───────────────────────────────────╱        │
                         │ YES                        │
                         ▼                      S2420 │
        ┌───────────────────────────────────┐        │
        │  Determine second expected battery │       │
        │       SOC for new destination      │       │
        └─────────────────┬─────────────────┘        │
                          │                    S2430  │
        ╱─────────────────────────────────╲    YES    │
       ╱   Second expected battery SOC ≤    ╲─────────┤
        ╲      Second reference SOC?        ╱          │
         ╲───────────────┬────────────────╱           │
                         │ NO                          │
                         ▼                      S2440  │
        ┌───────────────────────────────────┐         │
        │ Perform second pre-discharging     │         │
        │            operation               │         │
        └─────────────────┬─────────────────┘         │
                          │◄──────────────────────────┘
                          ▼
                    ┌──────────┐
                    │   End    │
                    └──────────┘
```

# EP 4 769 290 A1

## INTERNATIONAL SEARCH REPORT

| International application No. |
| --- |
| **PCT/KR2025/010198** |

| | |
| --- | --- |
| **A.** | **CLASSIFICATION OF SUBJECT MATTER** |

**G06Q 50/40**(2024.01)i; **G06Q 50/10**(2012.01)i; **B60L 58/12**(2019.01)i; **G01R 31/382**(2019.01)i; **G08B 21/18**(2006.01)i; **B60L 58/10**(2019.01)i; **G06V 20/62**(2022.01)i; **H01M 10/42**(2006.01)i

According to International Patent Classification (IPC) or to both national classification and IPC

| | |
| --- | --- |
| **B.** | **FIELDS SEARCHED** |

Minimum documentation searched (classification system followed by classification symbols)

G06Q 50/40(2024.01); B60L 58/12(2019.01); B60L 58/22(2019.01); G06Q 50/30(2012.01); G08G 1/14(2006.01); H01M 10/44(2006.01); H01M 10/48(2006.01); H01M 50/24(2021.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 전기 차량(electric vehicle), 위치(location), 배터리(battery), 입차 관리(entry management), 허용(allowance), 차단(blocking)

| | |
| --- | --- |
| **C.** | **DOCUMENTS CONSIDERED TO BE RELEVANT** |

| Category* | Citation of document, with indication, where appropriate, of the relevant passages | Relevant to claim No. |
| --- | --- | --- |
| Y | KR 10-2014-0016476 A (SSANGYONG MOTOR COMPANY) 10 February 2014 (2014-02-10) paragraphs [0051]-[0065]; and figure 4 | 1-15 |
| Y | KR 10-1886765 B1 (TRAWORKS et al.) 08 August 2018 (2018-08-08) paragraphs [0009]-[0014], [0055] | 1-15 |
| Y | KR 10-2023-0034597 A (HYUNDAI MOTOR COMPANY et al.) 10 March 2023 (2023-03-10) paragraphs [0061]-[0094]; and figures 1-4 | 2-8,10-15 |
| A | KR 10-2024-0058239 A (KONGJU NATIONAL UNIVERSITY INDUSTRY-UNIVERSITY COOPERATION FOUNDATION) 03 May 2024 (2024-05-03) paragraphs [0032], [0071] | 1-15 |
| A | US 2018-0062222 A1 (GM GLOBAL TECHNOLOGY OPERATIONS LLC) 01 March 2018 (2018-03-01) paragraphs [0030], [0045] | 1-15 |

☐ Further documents are listed in the continuation of Box C.   ☑ See patent family annex.

| | | | |
| --- | --- | --- | --- |
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **20 October 2025** | **20 October 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2025/010198**

| Patent document cited in search report | | | Publication date (day/month/year) | Patent family member(s) | | | Publication date (day/month/year) |
|---|---|---|---|---|---|---|---|
| KR | 10-2014-0016476 | A | 10 February 2014 | KR | 10-1369596 | B1 | 06 March 2014 |
| KR | 10-1886765 | B1 | 08 August 2018 | KR | 10-2019-0059197 | A | 30 May 2019 |
| KR | 10-2023-0034597 | A | 10 March 2023 | None | | | |
| KR | 10-2024-0058239 | A | 03 May 2024 | None | | | |
| US | 2018-0062222 | A1 | 01 March 2018 | CN | 107799812 | A | 13 March 2018 |
| | | | | CN | 107799812 | B | 08 December 2020 |
| | | | | DE | 102017119818 | A1 | 01 March 2018 |
| | | | | DE | 102017119818 | B4 | 13 March 2025 |
| | | | | US | 10622684 | B2 | 14 April 2020 |

Form PCT/ISA/210 (patent family annex) (July 2022)

## REFERENCES CITED IN THE DESCRIPTION

**Patent documents cited in the description**

- KR 1020240112949
- KR 1020240113766
- KR 1020250064633